(19) **Europäisches Patentamt**

**European Patent Office**

**Office européen des brevets**

(11) **EP 1 235 112 B1**

(12) **EUROPÄISCHE PATENTSCHRIFT**

(45) Veröffentlichungstag und Bekanntmachung des Hinweises auf die Patenterteilung:
**30.08.2006 Patentblatt 2006/35**

(51) Int Cl.:
*G03F 7/20* *(2006.01)* *G02B 13/14* *(2006.01)*
*G02B 13/18* *(2006.01)*

(21) Anmeldenummer: **02001958.4**

(22) Anmeldetag: **01.02.2002**

(54) **Teilobjektiv für Beleuchtungssystem**

Objective subsystem for illumination system

Partie d'objectif pour système d'illumination

(84) Benannte Vertragsstaaten:
**DE NL**

(30) Priorität: **23.02.2001 DE 10108677**

(43) Veröffentlichungstag der Anmeldung:
**28.08.2002 Patentblatt 2002/35**

(73) Patentinhaber: **Carl Zeiss SMT AG**
**73446 Oberkochen (DE)**

(72) Erfinder:
• **Schultz, Jörg**
**73430 Aalen (DE)**
• **Wangler, Johannes**
**89551 Königsbronn (DE)**

• **Sohmer, Alexander**
**73447 Oberkochen (DE)**
• **Epple, Alexander**
**73431 Aalen (DE)**
• **Grunwald, Jürgen**
**verstorben (DE)**

(74) Vertreter: **Müller-Rissmann, Werner Albrecht et al**
**Carl Zeiss,**
**Patentabteilung**
**73446 Oberkochen (DE)**

(56) Entgegenhaltungen:
**DE-A1- 19 653 983** **US-A- 4 906 080**

**Beschreibung**

Die Erfindung betrifft ein Teilobjektiv insbesondere für ein Beleuchtungssystem einer Mikrolithographie-Projektionsbelichtungsanlage, ein REMA-Objektiv, das ein derartiges Teilobjektiv aufweist und eine Mikrolithographie-Projektionsbelichtungsanlage mit einem derartigen Teilobjektiv.

Das Teilobjektiv umfaßt eine erste und eine zweite Linsengruppe, die zwischen einer Blendenebene und einer Bildebene angeordnet sind, wobei sich in der Bildebene ein auszuleuchtendes Bildfeld befindet. Die Komponenten sind dabei zentriert um eine optische Achse angeordnet. Durch die Blendenebene treten Strahlenbüschel mit je einem Hauptstrahl in das Teilobjektiv ein, wobei die Hauptstrahlen die optische Achse im Bereich der Blendenebene schneiden. Dabei beträgt der axiale Abstand der Schnittpunkte der Hauptstrahlen mit der optischen Achse maximal 10% des Durchmessers der Blende. Die axiale Ablage der Schnittpunkte hängt von den Aberrationen der Pupillenabbildung ab, die durch die vor dem Teilobjektiv angeordneten Systemteile eingeführt werden. Die Pupillenabbildung bezeichnet dabei die Abbildung zwischen Pupillenebenen. Der äußerste Hauptstrahl, der unter maximalem Winkel zur optischen Achse durch die Blendenebene läuft, trifft in der Bildebene auf den Rand des Bildfeldes. Das Strahlbüschel, dessen Hauptstrahl entlang der optischen Achse verläuft, definiert ein Mittenbüschel. Die erste Linsengruppe umfaßt dabei diejenigen Linsen, bei denen der äußerste Hauptstrahl dem Betrag nach kleinere Strahlhöhen an den Linsenflächen aufweist als der Randstrahl des Mittenbüschels. Die zweite Linsengruppe umfaßt diejenigen Linsen, bei denen der äußerste Hauptstrahl dem Betrag nach größere Strahlhöhen an den Linsenflächen aufweist als der Randstrahl des Mittenbüschels. Eine Linse der zweiten Linsengruppe weist dabei eine asphärische Linsenfläche auf.

Aus der DD 292 727 ist eine Mikrolithographie-Projektionsbelichtungsanlage bekannt, die innerhalb der Beleuchtungseinrichtung zwischen einem Wabenkondensor und einer Struktur tragenden Maske ein gattungsgemäßes Teilobjektiv aufweist. Nach der Struktur tragenden Maske folgt im Strahlengang ein Projektionsobjektiv, das die Struktur tragende Maske beugungsbegrenzt auf ein lichtempfindliches Substrat abbildet. Der ersten Linsengruppe des Teilobjektives entspricht in der DD 292 727 der Kollimator und der zweiten Linsengruppe die aus einer Linse bestehende Feldlinse. Die Feldlinse weist dabei eine asphärische Korrekturfläche auf, um die Winkelverteilung der Hauptstrahlen in der Bildebene des Teilobjektives derart zu beeinflussen, daß die Bildebene des Projektionsobjektives nahezu telezentrisch beleuchtet wird. Durch die asphärische Korrekturfläche werden die Aberrationen der Pupillenabbildung zwischen der Blendenebene des Teilobjektives und der Blendenebene des Projektionsobjektives reduziert. Nachteilig an der Anordnung der DD 292 727 sind die begrenzten Möglichkeiten zur Korrektion der Pupillenabbildung, da die Feldlinse nur aus einer einzigen Linse mit positiver Brechkraft besteht. Zudem weist das Ausführungsbeispiel nur eine bildseitige numerische Apertur von 0,04 und eine maximale Feldhöhe von 71,75mm auf.

Aus der DE 195 48 805 A1 (US 5,982,558) und der DE 196 53 983 A1 (US serial No.09/125621) der Anmelderin sind sogenannte REMA-Objektive bekannt geworden. REMA-Objektive werden in Mikrolithographie-Projektionsbelichtungsanlagen unmittelbar vor der Struktur tragenden Maske, dem sogenannten Retikel, eingesetzt. Sie bilden Maskierungseinrichtungen, sogenannte REMA (Reticle Masking)-Blades randscharf auf das Retikel ab. Die REMA-Blades sind gewöhnlich mit verstellbaren mechanischen Schneiden ausgeführt, durch die sich die Größe des Objektfeldes des nachfolgenden REMA-Objektives verändern läßt. Während in dem Ausführungsbeispiel der DE 195 48 805 A1 ein REMA-Objektiv mit rein sphärischen Linsen gezeigt ist, wird in der DE 196 53 983 A1 der Einsatz von asphärischen Linsen zur Reduzierung der Anzahl der Linsen innerhalb eines REMA-Objektives vorgeschlagen. Der Feldlinsenteil eines REMA-Objektives paßt dabei die Winkelverteilung der Hauptstrahlen des REMA-Objektives an die Winkelverteilung der Hauptstrahlen eines nachfolgenden Projektionsobjektives an, um einen kontinuierlichen Strahlverlauf zwischen dem REMA-Objektiv und dem Projektionsobjektiv zu erzielen.

Die EP 0 811 865 A2 zeigt ein Teilobjektiv, das zwischen einer Blendenebene und einer Bildebene angeordnet ist. In der Bildebene des Teilobjektives ist dabei nicht das Retikel, sondern eine Maskierungseinrichtung angeordnet, die mit einem nachfolgenden Objektiv auf das Retikel abgebildet wird. Das Teilobjektiv hat deshalb keinen direkten Einfluß auf die Verteilung der Hauptstrahlwinkel an der Schnittstelle zwischen der Beleuchtungseinrichtung und einem nachfolgenden Projektionsobjektiv.

Mit modernen Projektionsobjektiven lassen sich mikrostrukturierte Bauteile mit Strukturgrößen unter $0,2\mu m$ herstellen. Um diese hohen Auflösungen zu erreichen, werden die Projektionsobjektive bei Wellenlängen von 248nm, insbesondere 193nm oder sogar 157nm betrieben und weisen bildseitige numerische Aperturen von größer als 0,65 auf. Gleichzeitig sind die Bildfelddurchmesser zum Teil größer als 20mm. Die Anforderungen an das optische Design für ein derartiges Projektionsobjektiv sind deshalb beträchtlich. Neben der Feldabbildung des Retikels auf das lichtempfindliche Substrat, dem sogenannten Wafer, ist auch die Pupillenabbildung zu korrigieren. So beeinflußt der zwischen Objektebene und Blendenebene angeordnete vordere Objektivteil eines Projektionsobjektives die Abbildung der Eintrittspupille auf die Blendenebene, während der zwischen Blendenebene und Bildebene angeordnete hintere Objektivteil die Abbildung der Blendenebene auf die Austrittspupille beeinflußt. Die Aberrationen der Pupillenabbildung des Projektionsobjektives zeigen sich dabei in der Verteilung der Hauptstrahlwinkel in der Objektebene des Projektionsobjektives.

Aufgabe der Erfindung ist es, gattungsgemäße Teilobjektive anzugeben, die eine Beeinflussung der Verteilung der Hauptstrahlwinkel in der Bildebene des Teilobjektives über weite Bereiche zulassen. Insbesondere sollen Aberrationen der Pupillenabbildung, die durch den vorderen Objektivteil eines nachfolgenden Projektionsobjektives eingeführt werden, kompensiert werden.

Gelöst wird diese Aufgabe mit einem Teilobjektiv gemäß Anspruch 1. Die spezielle Ausgestaltung der Erfindung wird in den abhängigen Ansprüchen 2 bis 23 beschrieben. Die Ansprüche 1 bis 18 betreffen das erfindungsgemäße Teilobjektiv, die Ansprüche 19 bis 22 den Einsatz eines derartigen Teilobjektives innerhalb eines REMA-Objektives. Die Verwendung des erfindungsgemäßen Teilobjektives in einer Mikrolithographie-Projektionsbelichtungsanlage wird in Anspruch 23 beschrieben.

Die Verteilung der Hauptstrahlwinkel PF über die Feldhöhe $Y_{im}$ in der Bildebene des erfindungsgemäßen Teilobjektives, die sogenannte Pupillenfunktion, läßt sich als Reihenentwicklung mit ungeraden Potenzen darstellen. Die Polynomreihe lautet:

$$PF(Y_{im}) = \sum_n c_n \cdot Y_{im}^n \quad (n = 1, 3, 5, 7, 9...). \tag{1}$$

Die Hauptstrahlwinkel PF, die zwischen der Flächennormalen der Bildebene und dem jeweiligen Hauptstrahl bestimmt werden, sind im Uhrzeigersinn negativ definiert. Aus Symmetriegründen weist die Pupillenfunktion für ein um die optische Achse zentriertes System keine Beiträge mit geraden Potenzen auf. Würde das Beleuchtungssystem in der Bildebene des erfindungsgemäßen Teilobjektives keine Aberrationen der Pupillenabbildung aufweisen, so würde sich für jede Feldhöhe $Y_{im}$ die gleiche axiale Position der Austrittspupille, also eine homozentrische Austrittspupille ergeben. Da alle Hauptstrahlen sich bei homozentrischer Austrittspupille in einem Punkt auf der optischen Achse schneiden, besteht ausschließlich ein linearer Zusammenhang zwischen der Feldhöhe $Y_{im}$ und dem Tangens des Winkels für jeden Hauptstrahl. Bei sehr kleinen Hauptstrahlwinkeln, wie dies im folgenden der Fall sein wird, läßt sich der Tangens des Hauptstrahlwinkels durch den Winkel direkt annähern. Die Pupillenfunktion weist für eine homozentrische Pupille nur einen linearen Beitrag $c_1 \cdot Y_{im}$ auf, wobei der Koeffizient $c_1$ der Steigung der Pupillenfunktion bei $Y_{im} = 0mm$ entspricht. Durch die Aberrationen der Pupillenabbildung ergibt sich jedoch für jede Feldhöhe eine unterschiedliche axiale Position der Austrittspupille. Die feldabhängige Lage der Austrittspupille wird durch den nichtlinearen Beitrag

$$PF_{NL}(Y_{im}) = \sum_n c_n \cdot Y_{im}^n \quad (n = 3, 5, 7, 9...) \tag{2}$$

der Pupillenfunktion beschrieben. Die Beiträge höherer Ordnung entsprechen dabei der sphärischen Winkelaberration der Pupillenabbildung, also der sphärischen Aberration als Winkelaberration ausgedrückt. Ein optisches System mit positiver Brechkraft ist ohne spezielle Korrektionsmaßnahmen üblicherweise sphärisch unterkorrigiert, so daß der nichtlineare Beitrag $PF_{NL}$ der Pupillenfunktion für eine positive Feldhöhe negativ ist. Die Pupillenfunktion des erfindungsgemäßen Teilobjektives weist dagegen einen nichtlinearen Beitrag $PF_{NL}$ auf, der für positive Feldhöhen deutlich positiv ist. Der nichtlineare Beitrag $PF_{NL}(Y_{im}^{max})$ zum Hauptstrahlwinkel für die maximale positive Feldhöhe $Y_{im}^{max}$ beträgt mindestens +15mrad. Das Teilobjektiv führt somit eine starke Überkorrektur der sphärischen Aberration der Pupillenabbildung ein. Dies ist deshalb besonders vorteilhaft, weil dadurch das nachfolgende Projektionsobjektiv in Bezug auf die Pupillenabbildung sphärisch unterkorrigiert sein kann und sich damit im Projektionsobjektiv Korrektionsmittel einsparen lassen. Es ist immer günstiger, diese Korrektionsmittel im Beleuchtungssystem unterzubringen, da die Qualitätsanforderungen an optische Elemente in einem Projektionsobjektiv deutlich höher sind als an optische Elemente im Beleuchtungssystem. Das erfindungsgemäße Teilobjektiv erreicht nun diese Überkorrektur bei einem Bildfeld, das mindestens einen Durchmesser von 80mm aufweist, und dessen bildseitige numerische Apertur mindestens 0,15 beträgt. Die bildseitige numerische Apertur bezeichnet dabei die durch den maximalen Blendendurchmesser des Teilobjektives mögliche numerische Apertur in der Bildebene. Der Lichtleitwert, der als Produkt von Bildfelddurchmesser und bildseitiger numerischer Apertur definiert ist, beträgt mindestens 12mm. Die Überkorrektur der sphärischen Aberration der Pupillenabbildung läßt sich erreichen, wenn die zweite Linsengruppe des erfindungsgemäßen Teilobjektives aus mindestens zwei Linsen besteht, wobei eine erste Linse eine negative Brechkraft, eine zweite Linse eine positive Brechkraft aufweist.

Besonders vorteilhaft zur Korrektion der sphärischen Aberration der Pupillenabbildung ist es, wenn die erste Linse negativer Brechkraft eine zur Bildebene konkave Linsenfläche aufweist, so daß der Krümmungsradius dieser Fläche positiv ist.

Dabei ist es günstig, wenn das Verhältnis von Krümmungsradius und Linsendurchmesser der konkaven Linsenfläche kleiner als 1,0, vorzugsweise kleiner als 0,8 ist. Dieses Verhältnis ist nach unten durch den Wert 0,5 begrenzt, der sich für eine Halbkugel ergibt. Durch die stark gekrümmte konkave Linsenfläche ergeben sich große Inzidenzwinkel an dieser Linsenfläche für die Hauptstrahlen der achsfernen Bildpunkte und damit ein großer Beitrag zur Überkorrektur der sphärischen Aberration der Pupillenabbildung.

Die erste Linse negativer Brechkraft ist vorzugsweise als Meniskus ausgelegt. Bei Meniskus-Linsen weist der Scheitelradius der Vorder- und Rückfläche das gleiche Vorzeichen auf.

Die erste Linse mit negativer Brechkraft sollte dabei möglichst nahe an der Bildebene angeordnet sein. Es ist vorteilhaft, wenn bis auf planparallele Platten, wie beispielsweise Filter oder Abschlußplatten, welche auch mit Freiform-Korrekturflächen versehen sein können, keine weiteren optischen Elemente im Strahlengang zwischen der ersten Linse und der Bildebene angeordnet sind.

Zur Korrektur der Feldabbildung, also der Abbildung der Strahlenbüschel in die Bildebene, ist es vorteilhaft, wenn die konkave Linsenfläche der ersten Linse eine zur Bildebene nahezu konzentrische Fläche ist. In diesem Fall treffen die Strahlen des Mittenbüschel mit geringen Inzidenzwinkeln auf die konkave Linsenfläche. Dies ist gegeben, wenn das Verhältnis des Abstandes der Bildebene von dem Scheitel der konkaven Linsenfläche zum Betrag des Krümmungsradius der konkaven Linsenfläche einen Wert zwischen 0,7 und 1,3 aufweist. Während die Strahlen des Mittenbüschels nahezu ungebrochen durch die nahezu zur Bildebene konzentrische Linsenfläche treten, ergeben sich für die Strahlenbüschel der achsfernen Bildpunkte große Inzidenzwinkel. Die Fläche läßt sich somit ideal zur Korrektur der feldabhängigen Bildfehler einsetzen, während das Mittenbüschel nahezu unbeeinflußt bleibt.

Befinden sich zwischen der ersten Linse mit der zur Bildebene konkaven Linsenfläche und der Bildebene keine weiteren Linsen mit optischer Brechkraft, so ist es vorteilhaft, wenn der halbe Krümmungsradius der konkaven Linsenfläche deutlich größer oder kleiner als der Abstand des Scheitels der konkaven Linsenfläche von der Bildebene ist. Diese Forderung an den Krümmungsradius der konkaven Linsenfläche kommt dann zum Tragen, wenn sich in der Bildebene das Retikel befindet, das üblicherweise einen Teil der auftreffenden Lichtstrahlen in das Teilobjektiv zurück reflektiert. Da jede optische Fläche selbst bei einer Antireflex-Beschichtung eine Restreflexion aufweist, würde das von der Maske reflektierte Licht an der zur Bildebene konkaven Linsenfläche wiederum in Richtung der Maske reflektiert. Bei einer nahezu telezentrischen Beleuchtung der Maske würde sich ein Störreflex ergeben, wenn sich die Bildebene im Abstand der Brennweite der als Spiegel wirkenden konkaven Linsenfläche befinden würde. Die Brennweite eines Konkavspiegels ist durch den halben Krümmungsradius gegeben. Ein Störreflex kann vernachlässigt werden, wenn der Betrag der Differenz des Abstandes der konkaven Linsenfläche von der Bildebene und der Brennweite größer ist als der Betrag der Brennweite mit dem Faktor 0,3 multipliziert.

Die Minimierung der Störreflexe wird auch für die anderen Flächen der zweiten Linsengruppe berücksichtigt. Damit zwischen dem Retikel und den Linsenflächen der zweiten Linsengruppe keine Störreflexe entstehen, ist die zweite Linsengruppe derart aufgebaut, daß der äußerste Hauptstrahl, der mit maximalem Winkel zur optischen Achse durch die Blendenebene läuft, nach einer Reflexion an der Bildebene und einer Reflexion an einer Linsenfläche der zweiten Linsengruppe in der Bildebene eine Strahlhöhe aufweist, die mindestens 30% der maximalen Feldhöhe $Y_{im}^{max}$ beträgt.

Bei konstanter Brechkraft des Teilobjektives läßt sich dies durch die Variation der Durchbiegung der Linsenflächen erreichen. Der äußerste Hauptstrahl wird deshalb zur Abschätzung der Störreflexe herangezogen, da sein Schnittpunkt mit der Bildebene den 50%-Punkt des Störreflexes markiert. Würde der äußerste Hauptstrahl jedoch die Bildebene im Bereich der optischen Achse schneiden, so würden alle weiteren Hauptstrahlen ebenfalls in diesem Bereich die Bildebene schneiden und die zweifach reflektierten Strahlbüschel in einem engen Bereich um die optische Achse auftreffen, so daß sich ein deutlicher Störreflex ergibt.

Die erste asphärische Linsenfläche zeichnet sich durch eine große Pfeilhöhenabweichung von mindestens 0,2mm, vorzugsweise 0,4mm bezüglich einer Hüllsphäre aus. Diese großen Asphärizitäten sind ein weiteres Korrektionsmittel, um die Überkorrektur der sphärischen Aberration der Pupillenabbildung bereitzustellen. Die Pfeilhöhen sind als Abstände zwischen der asphärischen Linsenfläche und der Hüllsphäre in Richtung der optischen Achse definiert. Als Hüllsphäre wird eine sphärische Fläche bezeichnet, die den gleichen Scheitel wie die asphärische Fläche aufweist und die asphärische Linsenfläche am Rand des ausgeleuchteten Bereiches der asphärischen Linsenfläche schneidet. Der ausgeleuchtete Bereich wird durch die Randstrahlen des Strahlenbüschels des äußersten Hauptstrahls begrenzt.

Erschwerend für die Auslegung des Teilobjektives kommt hinzu, daß der bildseitige Arbeitsabstand des Teilobjektives mindestens 30mm, vorzugsweise mindestens 40mm betragen sollte. Der freie Arbeitsabstand bezeichnet dabei den Abstand der Bildebene vom Scheitel der letzten optischen Fläche des Teilobjektives, wobei dieser Abstand um die maximale Pfeilhöhe der letzten optischen Fläche verringert wird, falls es sich bei dieser Fläche um eine konkave Fläche handelt. Der freie Arbeitsabstand ermöglicht den freien Zugang zur Bildebene, in der sich üblicherweise das Retikel befindet. Vorrichtungen zum Positionieren und Wechseln des Retikels müssen in diesen Raum eingreifen können.

Mit dem erfindungsgemäßen Teilobjektiv ist es möglich, die sphärische Aberration der Pupillenabbildung derart überzukorrigieren, daß der nichtlineare Beitrag $PF_{NL}(Y_{im}^{max})$ zum Hauptstrahlwinkel für die maximale positive Feldhöhe $Y_{im}^{max}$ mindestens +25mrad beträgt

Dies läßt sich unter anderem dadurch erreichen, daß die zweite Linsengruppe eine zweite asphärische Linsenfläche aufweist.

Die maximale Pfeilhöhenabweichung der zweiten asphärischen Linsenfläche von der Hüllsphäre sollte möglichst größer als 0,2mm, vorzugsweise größer als 0,4mm sein.

Es ist vorteilhaft, wenn für die maximale Feldhöhe $Y_{im}^{max}$ das Verhältnis des nichtlinearen Beitrags $PF_{NL}(Y_{im}^{max})$ zum linearen Beitrag $c_1 \cdot Y_{im}^{max}$ im Bereich von -0,5 und -2,0 liegt. Dann läßt sich durch den linearen Anteil der Pupillenfunktion der nichtlineare Anteil für die maximale Feldhöhe teilweise kompensieren, so daß sich für die positiven Feldhöhen nahezu gleich große maximale und minimale Hauptstrahlwinkel ergeben und die Hauptstrahlen für diese Feldhöhen im Mittel parallel zur optischen Achse verlaufen. Der lineare Anteil der Pupillenfunktion wird über die paraxiale Lage der Austrittspupille eingestellt.

Neben der Beeinflussung der sphärischen Aberration der Pupillenabbildung fokussiert das Teilobjektiv die eintretenden Strahlbüschel auf Spotbilder mit minimalem Durchmesser in der Bildebene. Dazu ist die Korrektur der Feldabbildung erforderlich. Der maximale Spotdurchmesser für alle Spotbilder beträgt vorteilhafterweise 2% der maximalen Feldhöhe $Y_{im}^{max}$. Zur Bestimmung des Spotbildes und des Spotdurchmessers werden die Strahlenbüschel bei voller Öffnung der Blende betrachtet, so daß die Strahlenbüschel die maximale bildseitige numerische Apertur ausleuchten. Das Spotbild ist dabei durch die Durchstoßpunkte der Strahlen eines Strahlenbüschels mit der Bildebene gegeben. Als Korrektionsmittel steht primär die erste Linsengruppe zur Verfügung, die vorteilhafterweise aus einem Meniskus mit positiver Brechkraft und einem Meniskus mit negativer Brechkraft besteht. Zusätzlich ist es günstig, in der ersten Linsengruppe eine asphärische Linsenfläche vorzusehen.

Zur gleichzeitigen Korrektur der Pupillenabbildung und der Feldabbildung ist es günstig, wenn die zweite Linse mit positiver Brechkraft ein Meniskus ist.

Vorteilhafterweise besteht die zweite Linsengruppe aus drei bis fünf Linsen, um die Feldabbildung zu korrigieren, die sphärische Aberration der Pupillenabbildung überzukorrigieren und eine gleichmäßige Beleuchtung des Bildfeldes zu gewährleisten.

Dies ist insbesondere durch den zusätzlichen Einsatz einer Bikonvexlinse in der zweiten Linsengruppe möglich.

Das erfindungsgemäße Teilobjektiv läßt sich vorteilhaft innerhalb eines REMA-Objektives einsetzen, wobei das REMA-Objektiv ein Objektfeld mit drei- bis achtfacher Vergrößerung auf ein Bildfeld abbildet. Das REMA-Objektiv besteht dabei aus einem ersten Teilobjektiv zwischen der Objektebene und der Blendenebene und dem erfindungsgemäßen Teilobjektiv. Beide Teilobjektive weisen dabei eine gemeinsame optische Achse auf. Die Vergrößerung des REMA-Objektivs läßt sich über das Verhältnis der Brennweiten des ersten und zweiten Teilobjektiv einstellen. Von der Objektebene ausgehende Hauptstrahlen müssen dabei nicht unbedingt die Blendenebene in einem Punkt schneiden, wenn die Pupillenabbildung des ersten Teilobjektives oder der vor dem REMA-Objektiv angeordneten optischen Komponenten fehlerbehaftet ist.

Da das REMA-Objektiv die in der Objektebene des REMA-Objektives angeordnete Maskierungseinrichtung möglichst scharf auf die Bildebene, in der das Retikel angeordnet ist, abbilden soll, weisen die Spotbilder der Objektpunkte in der Bildebene minimale Durchmesser auf. Der maximale Durchmesser der Spotbilder beträgt 2% der maximalen Feldhöhe $Y_{im}^{max}$. Zur Bestimmung des maximalen Spotdurchmessers werden Strahlbüschel bei maximale Blendenöffnung, die der maximalen bildseitigen numerischen Apertur entspricht, verwendet.

Vorteilhafterweise befindet sich die Eintrittspupille des REMA-Objektives im Unendlichen, so daß die Hauptstrahlen der Strahlbüschel nach der Objektebene parallel zur optischen Achse und damit telezentrisch verlaufen. Durch diese Maßnahme ist der Abbildungsmaßstab des REMA-Objektives unabhängig von einer Defokussierung des Objektes, in diesem Fall der Maskierungseinrichtung.

Neben den Hauptstrahlen, die über die Pupillenabbildung definiert sind, sind in der Bildebene des REMA-Objektives auch die energetischen Schwerstrahlen von Bedeutung. Der energetische Schwerstrahl eines Strahlenbüschels stellt dabei den Strahl dar, der sich aus einer Mittelung über alle Strahlen des betrachteten Strahlenbüschels ergibt, wobei jeder Strahlen gemäß der Ausleuchtung der Eintrittspupille ein energetisches Gewicht aufweist. Für eine Feldhöhe $Y_{im}$ hängt die Richtung des entsprechenden energetischen Schwerstrahls von den Aberrationen des REMA-Objektives in Zusammenhang mit der Ausleuchtung der Eintrittspupille des REMA-Objektives ab. Die energetischen Schwerstrahlen lassen sich beispielsweise für eine vollständige Ausleuchtung der Eintrittspupille oder für eine nur teilweise Beleuchtung der Eintrittspupille bestimmen, wobei die Beleuchtung jeweils nahezu punktsymmetrisch zur optischen Achse ist. Das REMA-Objektiv ist nun so aufgebaut, daß die maximale Winkelabweichung zwischen energetischem Schwerstrahl und Hauptstrahl für alle Feldhöhen kleiner als 2mrad, vorzugsweise kleiner als 1 mrad ist. Erreicht wird diese Forderung zusammen mit den Anforderungen an die Feld- und Pupillenabbildung mit einem REMA-Objektiv, das acht bis zwölf Linsen mit endlicher Brennweite umfaßt, wobei das erste Teilobjektiv drei bis fünf Linsen, das zweite Teilobjektiv fünf bis sieben Linsen aufweist. Zusätzlich ist der Einsatz von drei bis fünf asphärischen Flächen vorteilhaft.

Das erfindungsgemäße Teilobjektiv wird vorteilhafterweise in einer Mikrolithographie-Projektionsbelichtungsanlage eingesetzt, wobei unmittelbar auf das Teilobjektiv ein Projektionsobjektiv folgt. Die Schnittstelle zwischen Beleuchtungssystem und Projektionsobjektiv stellt somit die Bildebene des Teilobjektives, beziehungsweise die Objektebene des Projektionsobjektives dar. Teilobjektiv und Projektionsobjektiv sind dabei zentriert um eine gemeinsame optische Achse angeordnet. Um einen kontinuierlichen Verlauf der Strahlbüschel von Beleuchtungssystem und Projektionsobjektiv zu gewährleisten, muß die Verteilung der Hauptstrahlwinkel des Teilobjektives an die Verteilung der Hauptstrahlwinkel des Projektionsobjektives an dieser Schnittstelle angepaßt sein. Die Abweichung der Pupillenfunktion des Teilobjektives von der objektseitigen Objektiv-Pupillenfunktion ist dabei vorteilhafterweise für alle Feldhöhen innerhalb des Bildfeldes des Teilobjektives kleiner als 2mrad, vorzugsweise kleiner als 1mrad. Ist diese Bedingung erfüllt, so bilden das Teilobjektiv und das Projektionsobjektiv in Bezug auf die Pupillenabbildung eine funktionelle Einheit. Projektionsobjektive, die an das erfindungsgemäße Teilobjektiv angepaßt sind, können dabei eine deutliche Unterkorrektion der sphärischen Aberration der Pupillenabbildung aufweisen, da mit dem Teilobjektiv die Aberrationen des Projektionsobjektives kompensiert werden können. Das entspannt die optische Korrektion des Projektionsobjektives wesentlich.

Entsprechend ist es vorteilhaft, ein REMA-Objektiv in einer Mikrolithographie-Projektionsbelichtungsanlage einzusetzen, wobei das REMA-Objektiv ein erfindungsgemäßes Teilobjektiv umfaßt.

Näher erläutert wird die Erfindung anhand der Zeichnungen.

Figur 1 zeigt den Linsenschnitt eines erfindungsgemäßen Teilobjektives;

Figur 2 zeigt ein Diagramm der Pupillenfunktion des Teilobjektives der Figur 1;

Figur 3 zeigt den Linsenschnitt eines ersten Ausführungsbeispiels eines REMA-Objektives;

Figur 4 zeigt ein Diagramm der Abweichung der Pupillenfunktion des REMA-Objektives der Figur 3 von der Verteilung der Schwerstrahlwinkel über der Feldhöhe;

Figur 5 zeigt den Linsenschnitt eines zweiten Ausführungsbeispiels eines REMA-Objektives;

Figur 6 zeigt ein Diagramm der Abweichung der Pupillenfunktion des REMA-Objektives der Figur 6 von der Verteilung der Schwerstrahlwinkel über der Feldhöhe;

Figur 7 zeigt eine Mikrolithographie-Projektionsbelichtungsanlage mit einem erfindungsgemäßen Teilobjektiv in schematischer Darstellung;

Figur 8 zeigt ein Diagramm der Abweichung der Pupillenfunktion des REMA-Objektives der Figur 3 von der objektsitigen Objektiv-Pupillenfunktion eines Projektionsobjektives gemäß Figur 2 aus DE 19942291.8;

Figur 9 zeigt ein weiteres Ausführungsbeispiel einer Mikrolithographie-Projektionsbelichtungsanlage mit einem erfindungsgemäßen REMA-Objektiv in schematischer Darstellung; und

Figur 10 zeigt ein Diagramm der Abweichung der Pupillenfunktion des REMA-Objektives der Figur 6 von der objektsitigen Objektiv-Pupillenfunktion eines Projektionsobjektives gemäß Figur 8 aus DE 19942291.8.

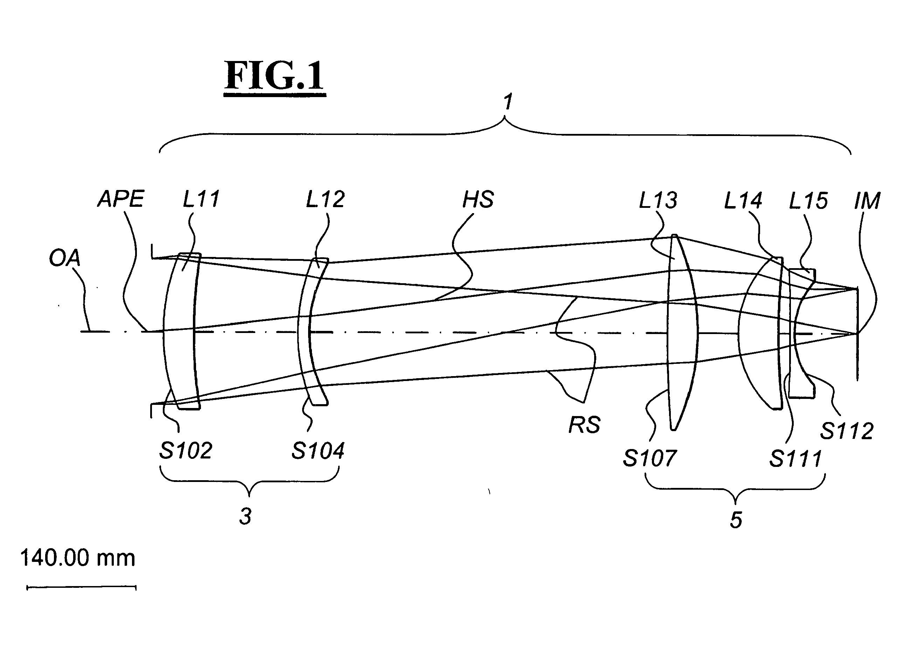

In Figur 1 ist der Linsenschnitt eines erfindungsgemäßen Teilobjektivs 1 dargestellt. Neben den Linsen sind die Randstrahlen RS des Mittenbüschels, sowie der äußerste Hauptstrahl HS und die das Strahlbüschel des äußersten Hauptstrahls begrenzenden Strahlen eingezeichnet. Das Teilobjektiv 1 ist dabei rotatiosnsymmetrisch um die optische Achse OA aufgebaut. Die Systemdaten sind in Tabelle 1 aufgeführt. Als Linsenmaterial wird in diesem Ausführungsbeispiel Quarz ($SiO_2$) eingesetzt, das bei der Arbeitswellenlänge $\lambda$ =193,3nm eine Brechzahl von 1,5603 aufweist. Als Linsenmaterial können auch Fluorid-Kristalle zum Einsatz kommen, wenn die Transmission erhöht werden oder das Teilobjektiv bei Wellenlängen von 157nm oder 126nm zum Einsatz kommen soll. Mit dem Teilobjektiv 1 wird in der Bildebene IM ein Bildfeld ausgeleuchtet, dessen Durchmesser 116,0mm beträgt. Die bildseitige numerische Apertur beträgt 0,18. Somit weist das Teilobjektiv einen Lichtleitwert von 20,7mm auf.

Durch die Blendenebene APE mit einem Durchmesser von 187,9mm treten parallele Strahlenbüschel in das Teilobjektiv ein, die in der Bildebene IM auf je einen Spot fokussiert werden. Innerhalb des Bildfeldes beträgt für alle Bildpunkte der maximale Spotdurchmesser 160$\mu$m. Die Größe des Spotdurchmessers wird durch die Korrektur der Feldabbildung und insbesondere durch die Korrektur der Bildschalen und der Öffnungsfehler bestimmt.

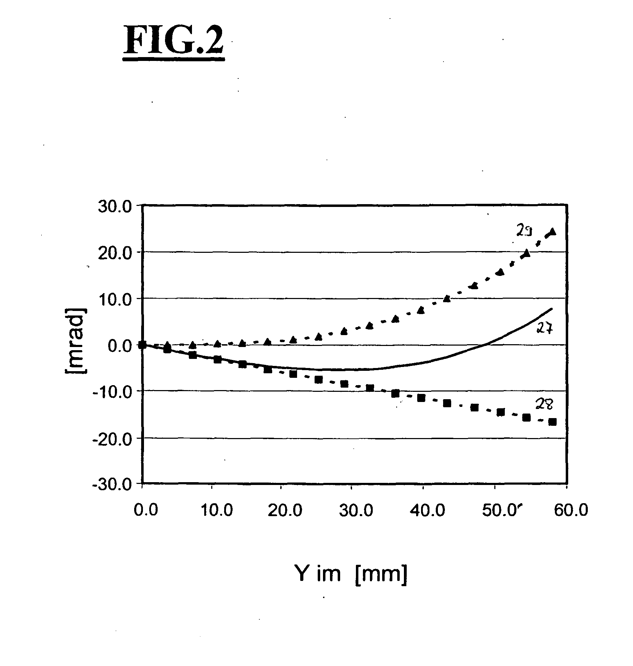

Die Hauptstrahlen der Strahlenbüschel schneiden beim Eintritt in das Teilobjektiv 1 der Figur 1 die optische Achse OA in der Mitte der Blendenebene APE. Der Winkel eines Hauptstrahls in der Blendenebene APE in Bezug auf die optische Achse korrespondiert dabei zu der Feldhöhe $Y_{im}$ des Hauptstrahls in der Bildebene IM. Der maximale Winkel eines Hauptstrahls in der Blendenebene APE beträgt 6,3° und entspricht in der Bildebene IM einer Feldhöhe $Y_{im}^{max}$ von 58,0mm. Die Brennweite des Teilobjektives 1 beträgt 487,7mm. Die Pupillenfunktion PF($Y_{im}$) des Teilobjektives 1, welche die Winkelverteilung der Hauptstrahlen in der Bildebene angibt, ist in Fig. 2 als durchgezogene Linie 27 dargestellt. Die Haupstrahlwinkel weisen für die positiven Feldhöhen Werte im Bereich von -5,3mrad und +7,9mrad auf, so daß die Hauptstrahlen für positive Feldhöhen im Mittel nahezu parallel zur optischen Achse verlaufen. Die Pupillenfunktion läßt sich als Polynomreihe gemäß Gleichung (1) entwickeln, deren Koeffizienten der Tabelle 2 zu entnehmen sind. Der Koeffizient $c_1$ erster Ordnung entspricht dabei der Steigung der Pupillenfunktion bei $Y_{im}$ = 0mm und gibt die paraxiale Lage der Austrittspupille, beziehungsweise die Lage der Austrittspupille bei aberrationsfreier Pupillenabbildung an. Die Koeffizienten der dritten und höherer Ordnungen beschreiben die sphärische Aberration der Pupillenabbildung. In Figur 2 ist der lineare Beitrag zur Pupillenfunktion als gestrichelte Linie 28 mit Quadraten als Markierung, der nichtlineare Beitrag als gestrichelte Linie 29 mit Dreiecken als Markierung eingezeichnet.

Tabelle 2: Koeffizienten der Polynomreihe

|  | Koeffizient | Polynombeiträge bei $Y_{im}^{max} = 58,0mm$ |
|---|---|---|
| $C_1$ | -2,8566E-01mrad/mm | -16,60 mrad |
| $C_3$ | 1.2526E-04mrad/mm$^3$ | 24,57 mrad |
| $C_5$ | -3.9215E-09mrad/mm$^5$ | -2,60 mrad |
| $C_7$ | 6.4435E-13mrad/mm$^7$ | 1,44 mrad |
| $C_9$ | 1.5273E-16mrad/mm$^9$ | 1,15 mrad |

In der dritten Spalte von Tabelle 2 sind die Polynombeiträge $c_n \cdot Y_{im}^n$ angegeben, die sich für die maximale positive Feldhöhe $Y_{im}^{max} = +58,0mm$ für die jeweilige Ordnung n ergeben. Der größte Beitrag zur sphärischen Aberration der Pupillenabbildung für die maximale positive Feldhöhe $Y_{im}^{max}$ ist der Beitrag dritter Ordnung mit +24,6mrad ist. Der gesamte nichtlineare Beitrag beträgt +24,6mrad. Da der nichtlineare Beitrag für die positive Feldhöhe ein positives Vorzeichen hat, ist die sphärische Aberration deutlich überkorrigiert. Das Verhältnis von nichtlinearem Beitrag zu linearem Beitrag beträgt für die maximale Feldhöhe $Y_{im}^{max}$ -1,48.

Das Teilobjektiv 1 ist aus einer ersten Linsengruppe 3 und einer zweiten Linsengruppe 5 aufgebaut. Die erste Linsengruppe 3 besteht aus der Linse L11 mit positiver Brechkraft und der Linse L12 mit negativer Brechkraft. Innerhalb der ersten Linsengruppe 3 verläuft der äußerste Hauptstrahl HS zwischen der optischen Achse OA und dem Randstrahl RS des Mittenbüschels. Die Linsen L11 und L12 weisen die asphärischen Linsenflächen S102 und S104 auf. Sowohl die Linse L11 wie auch die Linse L12 sind Menisken, deren konvexe Linsenfläche zur Blendenebene APE zeigen. Die erste Linsengruppe 3 trägt hauptsächlich zur Korrektur der Feldabbildung und damit zur Minimierung des Spotdurchmessers der Bildpunkte bei.

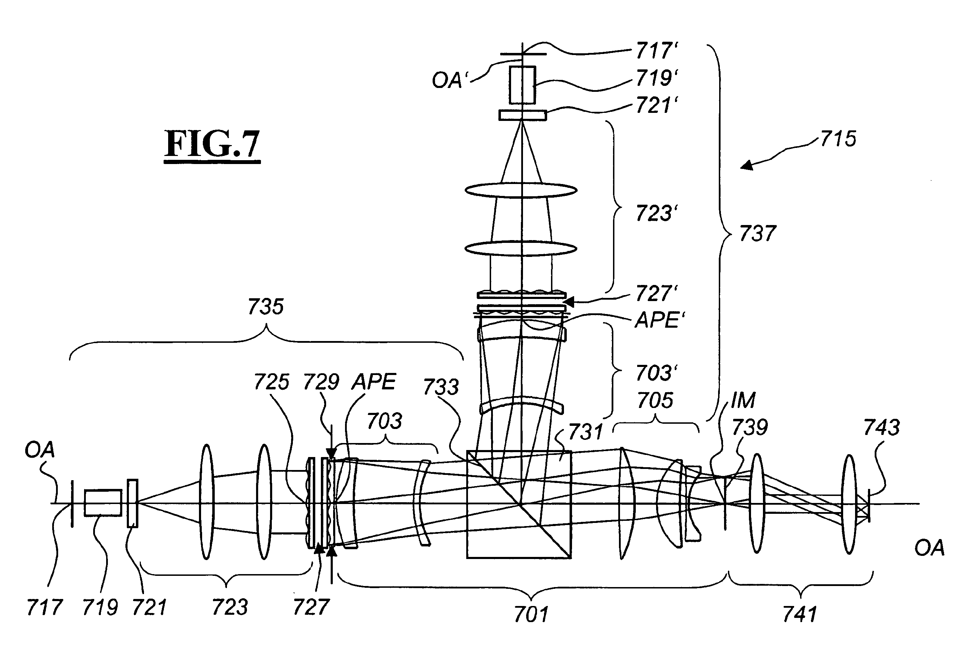

Bei den Linsen der zweiten Linsengruppe 5 verläuft der Randstrahl RS des Mittenbüschels zwischen der optischen Achse OA und dem äußersten Hauptstrahl HS. Zwischen der ersten Linsengruppe 3 und zweiten Linsengruppe 5 befindet sich ausreichend Bauraum, um einen Umlenkspiegel einzubringen. Mit dem Umlenkspiegel kann beispielsweise der Beleuchtungsstrahlengang um 90° abgelenkt werden. Alternativ ist es auch möglich, einen Strahlteiler einzubringen, um einen Teil des Beleuchtungslichtes für Meßzwecke auszukoppeln. Verwendet man einen Polarisations-Strahlteilerwürfel, so kann Licht aus zwei Lichtkanälen nahezu verlustfrei überlagert werden. Dazu ist die Strahlteilerschicht bei der 45°-Umlenkung des Strahlteilerwürfels derart ausgelegt, daß Licht, das senkrecht zur Einfallsebene polarisiert ist, nahezu vollständig reflektiert, während Licht, das parallel zur Einfallsebene polarisiert ist, nahezu vollständig transmittiert wird. Diese Anordnung wird im Ausführungsbeispiel der Figur 7 näher erläutert.

Die zweite Linsengruppe 5 in Figur 1 arbeitet als Feldlinse, die hauptsächlich die Pupillenabbildung beeinflußt. Zudem läßt sich die Verzeichnung in der Feldabbildung korrigieren, so daß sich die Intensitätsverteilung in der Bildebene IM korrigieren und anpassen läßt. Um diese Anforderungen zu erfüllen, ist die zweite Linsengruppe 5 aus der Bikonvexlinse L13 mit positiver Brechkraft, dem Meniskus L14 mit positiver Brechkraft und der Linse L15 mit negativer Brechkraft aufgebaut. Die Linsenfläche S111 ist eine asphärische Linsenfläche, deren Flächenbeschreibung in Tabelle 1 gegeben ist. Der Radius der Hüllsphäre, welche die asphärische Linsenfläche S 111 am Scheitel und am Rand des ausgeleuchteten Bereichs bei 80,4mm schneidet, beträgt -2218,4mm, so daß die maximale Pfeilhöhenabweichung zwischen der asphärischen Linsenfläche S 111 und der Hüllsphäre 0,28mm beträgt.

Die Linse L15 mit negativer Brechkraft weist eine zur Bildebene konkave Linsenfläche S112 auf, wobei das Verhältnis von Krümmungsradius zu Linsendurchmesser 0,75 beträgt. Die Linse L15 ist in Lichtrichtung die letzte Linse mit Brechkraft vor der Bildebene IM, so daß die konkave Linsenfläche S 112 unmittelbar vor der Bildebene IM angeordnet ist. Der freie Arbeitsabstand zwischen der letzten Linse L15 und der Bildebene IM beträgt 50,0mm.

Der freie Arbeitsabstand beschreibt den Bereich entlang der optischen Achse OA, in dem sich keine optischen Elemente des Teilobjektives befinden. Es besteht jedoch die Möglichkeit, nach der Linse L15 eine planparallele Abschlußplatte oder Intensitätsfilter anzubringen, die jedoch nur zu einer Verschiebung der Bildebene IM des Teilobjektives 1 führen.

Das Teilobjektiv 1 kommt üblicherweise in einer Beleuchtungseinrichtung einer Mikrolithographie-Projektionsbelichtungsanlage unmittelbar vor dem Retikel zum Einsatz. Da das Retikel einen Teil des einfallenden Lichtes in das Teilobjektiv 1 zurückreflektiert, sind die Linsen der zweiten Linsengruppe 5 vorteilhaft derart ausgelegt, daß Störreflexe minimiert werden, die dadurch zustande kommen, daß das am Retikel reflektierte Licht an einer Linsenfläche ein zweites Mal reflektiert wird und wieder auf das Retikel gelangt. Die Minimierung der Störreflexe wird erreicht, indem das Teilobjektiv 1 derart ausgelegt wird, daß der äußerste Hauptstrahl HS nach zweifacher Reflexion am Retikel und an einer Linsenfläche die Bildebene IM weit außerhalb der optischen Achse OA schneidet. Bei den Linsenflächen S 107 und S 112 gelangt der zweifach reflektierte Hauptstrahl HS zurück in die Bildebene IM, während bei Störreflexen zwischen der Bildebene und den Linsenflächen S 108, S109, S110 und S111 der äußerte Hauptstrahl gar nicht mehr in die Bildebene gelangt, sondern auf die Fassung des Teilobjektives 1 trifft. Bei Störreflexen zwischen der Bildebene und der Linsenfläche S107 schneidet der äußerste Hauptstrahl die Bildebene bei einer Höhe von 37,3mm, was einem Höhenverhältnis von 64,3% in Bezug auf die maximale Feldhöhe $Y_{im}^{max}$ entspricht. Bei Störreflexen zwischen der Bildebene und der Linsenfläche S 112 schneidet der äußerste Hauptstrahl die Bildebene bei einer Höhe von 107,7mm, was einem Höhenverhältnis von 185,7% in Bezug auf die maximale Feldhöhe $Y_{im}^{max}$ entspricht, so daß der zweifach reflektierte Hauptstrahl außerhalb des Bildfeldes auf die Bildebene IM trifft.

Die zur Bildebene IM konkave Linsenfläche S 112 ist kritisch für Störreflexe, wenn nach der Linse L15 keine weiteren Linsen mit Brechkraft folgen. Wäre der Abstand der Bildebene IM vom Scheitel der Linsenfläche S 112 gleich dem halben Krümmungsradius der Linsenfläche S112, so würde das von dem zu beleuchtenden Objekt in der Bildebene IM zurückreflektierte Licht in die Bildebene IM fokussiert werden, wenn die Bildebene IM nahezu telezentrisch wie im vorliegenden Fall beleuchtet wird. Die konkave Linsenfläche S112 weist dagegen einen Krümmungsradius von 100,7mm und einen Abstand von der Bildebene IM von 79,7mm auf, so daß die Brennebene der konkaven Linsenfläche S112, die zur Berechnung der Störreflexe als Spiegel fungiert, einen Abstand von 29,4mm zur Bildebene IM hat. Das Verhältnis dieses Abstandes zum halben Krümmungsradius beträgt 0,6, so daß sich ein möglicher Störreflex nur unwesentlich auswirkt.

Damit das Mittenbüschel mit geringen Inzidenzwinkeln auf die konkave Linsenfläche S 112 trifft und somit geringe Aberrationen für die Feldabbildung eingeführt werden, wird die konkave Linsenfläche S 112 möglichst konzentrisch zur Bildebene IM angeordnet. Das Verhältnis des Abstandes der Bildebene IM von dem Scheitel der konkaven Linsenfläche S112 zum Betrag des Krümmungsradius der konkaven Linsenfläche S112 beträgt 0,79.

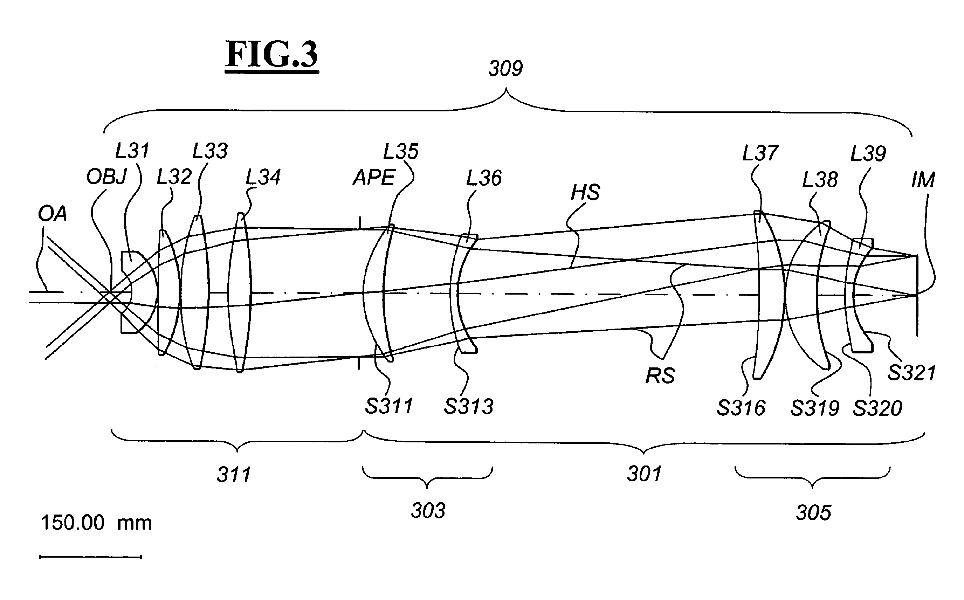

In Figur 3 ist der Linsenschnitt eines ersten Ausführungsbeispiels eines REMA-Objektivs 309 dargestellt. Neben den Linsen sind die Randstrahlen RS des Mittenbüschels, sowie der äußerste Hauptstrahl HS und die das Strahlbüschel des äußersten Hauptstrahls HS begrenzenden Strahlen eingezeichnet. Das REMA-Objektiv 309 ist dabei rotationssymmetrisch um die optische Achse OA aufgebaut. Die Systemdaten sind in Tabelle 3 aufgeführt. Als Linsenmaterialien werden in diesem Ausführungsbeispiel Kalziumfluorid-Kristall $CaF_2$ und Quarz ($SiO_2$) eingesetzt, die bei der Arbeitswellenlänge $\lambda$ =193,3nm eine Brechzahl von 1,5014 beziehungsweise 1,5603 aufweisen. Die den Elementen von Figur 1 entsprechenden Elemente in Figur 3 haben die gleichen Bezugszeichen wie in Figur 1 vermehrt um die Zahl 300. Für eine Beschreibung dieser Elemente wird auf die Beschreibung zu Figur 1 verwiesen.

Das REMA-Objektiv 309 der Figur 3 bildet ein Objektfeld mit einer Vergrößerung von $\beta$ = -3,74 auf ein Bildfeld ab. Es besteht dabei aus einem ersten Teilobjektiv 311 und einem zweiten Teilobjektiv 301, dessen Aufbau ähnlich zu dem Aufbau des Teilobjektivs 1 der Figur 1 ist. Mit dem REMA-Objektiv 309 wird in der Bildebene IM ein Bildfeld ausgeleuchtet, dessen Durchmesser 116,2mm beträgt. Die bildseitige numerische Apertur beträgt 0,18. Somit weist das REMA-Objektiv 309 einen Lichtleitwert von 20,9mm auf. Die Eintrittspupille des REMA-Objektives 309 befindet sich im Unendlichen, so daß die Hauptstrahlen in der Objektebene OBJ parallel zur optischen Achse OA verlaufen. Die Pupillenabbildung des ersten Teilobjektivs 311 ist möglichst gut korrigiert. Dennoch schneiden die Hauptstrahlen durch die von dem ersten Teilobjektiv 311 eingeführte sphärische Aberration und Bildfeldkrümmung der Pupillenabbildung die optische Achse OA nicht direkt in der Blendenebene APE, sondern abhängig von der Objekthöhe mit einer axialen Ablage in Bezug auf die Blendenebene APE. Beim REMA-Objektiv 309 der Figur 3 liegen die Schnittpunkte der Hauptstrahlen mit der optischen Achse OA in einem axialen Bereich von 5,4mm. Dies entspricht 2,9% des Blendendurchmessers, der 188mm beträgt.

Die von der Objektebene OBJ ausgehenden Strahlenbüschel werden in der Bildebene IM aufje einen Spot fokussiert. Innerhalb des Bildfeldes beträgt für alle Bildpunkte der maximale Durchmesser der Spotbilder 240μm.

Die Pupillenfunktion des REMA-Objektives 309 läßt sich als Polynomreihe gemäß Gleichung (1) entwickeln, deren Koeffizienten in Tabelle 4 gegeben sind.

Tabelle 4: Koeffizienten der Polynomreihe

|  | Koeffizient | Polynombeiträge bei $Y_{im}^{max} = 58,1mm$ |
|---|---|---|
| $C_1$ | -2,8278E-01 mrad/mm | -16,43 mrad |
| $C_3$ | 1,0607E-04 mrad/mm$^3$ | 20,08 mrad |
| $C_5$ | 6,5595E-09 mrad/mm$^5$ | 4,34 mrad |
| $C_7$ | -7,5251E-13 mrad/mm$^7$ | -1,68 mrad |
| $C_9$ | 7,9719E-17 mrad/mm$^9$ | 0,60 mrad |

Tabelle 4 ist zu entnehmen, daß der größte Beitrag zur sphärischen Aberration der Pupillenabbildung für die maximale positive Feldhöhe $Y_{im}^{max}$ der Beitrag dritter Ordnung mit +20,1mrad ist. Der gesamte nichtlineare Beitrag beträgt +24,1mrad, so daß die sphärische Aberration deutlich überkorrigiert ist. Das Verhältnis von nichtlinearem Beitrag zu linearem Beitrag beträgt für die maximale Feldhöhe $Y_{im}^{max}$ -1,46.

Das zweite Teilobjektiv 301 ist aus der ersten Linsengruppe 303 und der zweiten Linsengruppe 305 aufgebaut. Zu der ersten Linsengruppe 303 sind die Linsen L35 und L36 zu rechnen, wobei Linse L35 ein Meniskus mit positiver Brechkraft und Linse L36 ein Meniskus mit negativer Brechkraft ist. Die konvexe Fläche der Menisken ist dabei jeweils der Blendenebene APE zugewandt. Die Linsen der ersten Linsengruppe 303 weisen jeweils eine asphärische Linsenfläche S311 und S313 auf.

Die zweite Linsengruppe 305 des zweiten Teilobjektivs 301 ist aus dem Meniskus L37 mit positiver Brechkraft, dessen konvexe Linsenfläche der Bildebene IM zugewandt ist, dem Meniskus L38 mit positiver Brechkraft, dessen konvexe Linsenfläche der Blendenebene APE zugewandt ist, sowie dem Meniskus L39 mit negativer Brechkraft, dessen konvexe Fläche der Blendenebene APE zugewandt ist, aufgebaut. Die Linsenfläche S320 ist eine asphärische Linsenfläche, deren Flächenbeschreibung in Tabelle 3 gegeben ist. Der Radius der Hüllsphäre, welche die asphärische Linsenfläche S320 am Scheitel und am Rand des ausgeleuchteten Bereiches der asphärischen Linsenfläche S320 bei einer Höhe von 81,1mm schneidet, beträgt 317,1mm, so daß die maximale Pfeilhöhenabweichung zwischen der asphärischen Linsenfläche S320 und der Hüllsphäre 0,87mm beträgt.

Die Linse L39 mit negativer Brechkraft weist eine zur Bildebene IM konkave Linsenfläche S321 auf, wobei das Verhältnis von Krümmungsradius zu Linsendurchmesser 0,74 beträgt. Die Linse L39 ist die letzte Linse mit Brechkraft vor der Bildebene IM, so daß die konkave Linsenfläche S321 unmittelbar vor der Bildebene IM angeordnet ist. Der freie Arbeitsabstand zwischen der letzten Linse L39 und der Bildebene IM beträgt 64,8mm.

Da in der Bildebene IM des REMA-Objektives 309 das Retikel angeordnet wird, müssen die Linsen der zweiten Linsengruppe 305 des zweiten Teilobjektives 301 auf Minimierung der Störreflexe optimiert werden, die sich zwischen dem teilweise reflektierenden Retikel und den mit Restreflexen behafteten Linsenflächen ausbilden können. Kritisch für Störreflexe sind die Linsenflächen S316, S319, S320 und S321, während bei den Linsenflächen S317 und S318 der am Retikel und den benannten Linsenflächen reflektierte äußerte Hauptstrahl HS nicht mehr in die Bildebene gelangt, sondern noch innerhalb des REMA-Objektives 309 auf die Objektivfassung trifft. Bei Störreflexen zwischen der Bildebene IM und der Linsenfläche S316 schneidet der zweifach reflektierte Hauptstrahl HS die Bildebene IM bei einer Höhe von 41,9mm, was einem Höhenverhältnis von 72% in Bezug auf die maximale Feldhöhe $Y_{im}^{max}$ entspricht. Bei Störreflexen zwischen der Bildebene IM und der Linsenfläche S319 schneidet der zweifach reflektierte. Hauptstrahl HS die Bildebene IM bei einer Höhe von 59,8mm, was einem Höhenverhältnis von 102,9% in Bezug auf die maximale Feldhöhe $Y_{im}^{max}$ entspricht. Bei Störreflexen zwischen der Bildebene IM und der Linsenfläche S320 schneidet der zweifach reflektierte Hauptstrahl HS die Bildebene IM bei einer Höhe von 83,3mm, was einem Höhenverhältnis von 143,4% in Bezug auf die maximale Feldhöhe $Y_{im}^{max}$ entspricht. Bei Störreflexen zwischen der Bildebene IM und der Linsenfläche S321 schneidet der zweifach reflektierte Hauptstrahl HS die Bildebene IM bei einer Höhe von 158,8mm, was einem Höhenverhältnis von 273,3% in Bezug auf die maximale Feldhöhe $Y_{im}^{max}$ entspricht.

Die konkave Linsenfläche S321 weist einen Krümmungsradius von 101,80mm und einen Abstand von der Bildebene IM von 91,62mm auf, so daß die Brennebene der konkaven Linsenfläche S321, die zur Berechnung der Störreflexe als Spiegel fungiert, einen Abstand von 40,7mm zur Bildebene IM hat. Das Verhältnis dieses Abstandes zum halben Krümmungsradius beträgt 0,8, so daß sich ein möglicher Störreflex nur unwesentlich auswirkt.

Damit das Mittenbüschel mit geringen Inzidenzwinkeln auf die konkave Linsenfläche S321 trifft und somit geringe Aberrationen für die Feldabbildung eingeführt werden, wird die konkave Linsenfläche S321 möglichst konzentrisch zur Bildebene IM angeordnet. Das Verhältnis des Abstandes der Bildebene IM von dem Scheitel der konkaven Linsenfläche S321 zum Betrag des Krümmungsradius der konkaven Linsenfläche S321 beträgt 0,90.

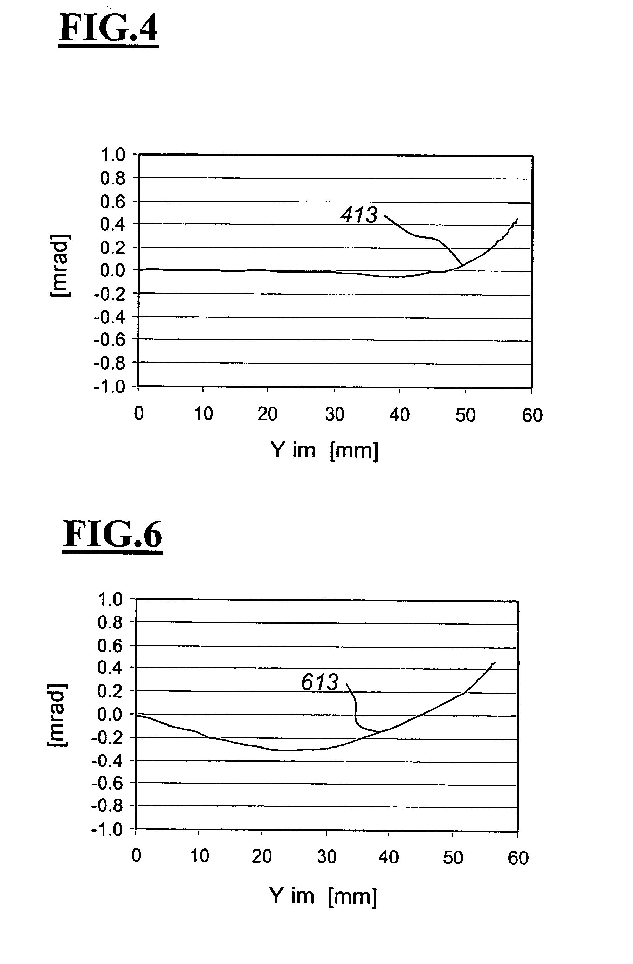

Durch die Aberrationen der Feldabbildung des REMA-Objektives 309 stimmt der für einen Bildpunkt der energetische Schwerstrahl nicht mit dem entsprechenden Hauptstrahl überein. Während in der Objektebene OBJ der energetische Schwerstrahl und der Hauptstrahl für jeden Bildpunkt übereinstimmen und parallel zur optischen Achse OA verlaufen, führen Koma und schiefe sphärische Aberration bei Bildpunkten außerhalb der optischen Achse OA zu einer Differenz zwischen energetischem Schwerstrahl und Hauptstrahl. Die Richtung des energetischen Schwerstrahls hängt dabei von der Ausdehnung der Strahlenbüschel in der Blendenebene APE ab. Leuchtet ein Strahlenbüschel die Blendenebene APE vollständig aus, so ist auf Grund der größeren Koma eine größere Abweichung der energetischen Schwerstrahlen von den Hauptstrahlen zu erwarten als bei Strahlenbüscheln, welche die Blendenebene APE nur in einem Bereich um die optische Achse OA ausleuchten. Extrem werden die Koma-Beiträge bei annularer Ausleuchtung der Blendenebene APE, da in diesem Fall die Strahlenbüschel nur die äußeren Aperturstrahlen aufweisen. Die Koma und die schiefe sphärische Aberration sind bei dem REMA-Objektiv 309 der Figur 3 so korrigiert, daß die Abweichung der Winkel der energetischen Schwerstrahlen bei vollständiger Ausleuchtung der Blendenebene von den Hauptstrahlwinkeln für alle Feldhöhen kleiner als $\pm0,5$mrad ist. Die Winkelabweichung ist in Figur 4 für positive Feldhöhen als durchgezogenen Linie dargestellt.

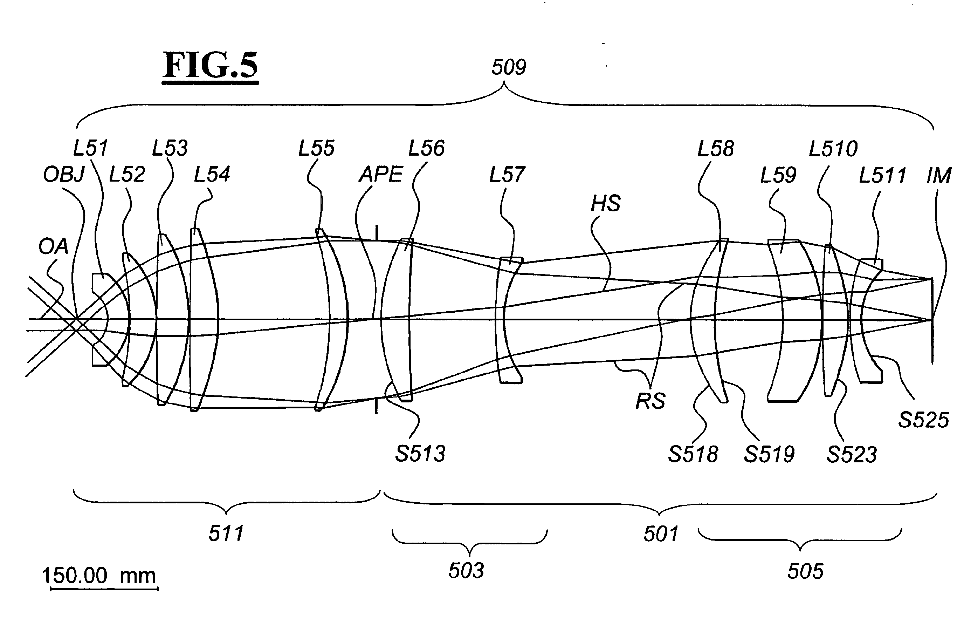

In Figur 5 ist der Linsenschnitt eines zweiten Ausführungsbeispiels eines REMA-Objektivs 509 dargestellt. Neben den Linsen sind die Randstrahlen RS des Mittenbüschels, sowie der äußerste Hauptstrahl HS und die das Strahlbüschel des äußersten Hauptstrahls HS begrenzenden Strahlen eingezeichnet. Das REMA-Objektiv 509 ist dabei rotationssymmetrisch um die optische Achse OA aufgebaut. Die Systemdaten sind in Tabelle 5 aufgeführt. Als Linsenmaterial wird in diesem Ausführungsbeispiel Quarz ($SiO_2$) eingesetzt, das bei der Arbeitswellenlänge $\lambda$ =248,3nm eine Brechzahl von 1,5084 aufweist. Die den Elementen von Figur 1 und Figur 3 entsprechenden Elemente in Figur 3 haben die gleichen Bezugszeichen wie in Figur 1, beziehungsweise Figur 3 vermehrt um die Zahl 500, beziehungsweise 200. Für eine Beschreibung dieser Elemente wird auf die Beschreibung zu Figur 1, beziehungsweise Figur 3 verwiesen.

Das REMA-Objektiv 509 der Figur 5 bildet ein Objektfeld mit einer Vergrößerung von $\beta$ = -3,50 auf ein Bildfeld ab. Es besteht dabei aus einem ersten Teilobjektiv 511 und einem zweiten Teilobjektiv 501. Mit dem REMA-Objektiv 509 wird in der Bildebene IM ein Bildfeld ausgeleuchtet, dessen Durchmesser 113,3mm beträgt. Die bildseitige numerische Apertur beträgt 0,19. Somit weist das REMA-Objektiv 509 einen Lichtleitwert von 21,5mm auf, der nochmals größer ist als der Lichtleitwert des REMA-Objektives 309 der Figur 3. Die Eintrittspupille des REMA-Objektives 509 befindet sich im Unendlichen, so daß die Hauptstrahlen in der Objektebene OBJ parallel zur optischen Achse OA verlaufen. Durch die sphärische Aberration und Bildfeldkrümmung der Pupillenabbildung, die durch das erste Teilobjektiv 511 eingeführt wird, schneiden die Hauptstrahlen die optische Achse OA mit einer axialen Ablage zur Blendenebene APE. Beim REMA-Objektiv 509 der Figur 5 liegen die Schnittpunkte der Hauptstrahlen mit der optischen Achse OA 8,2mm auseinander. Dieser Abstand entspricht 3,8% des Blendendurchmessers, der 217,2mm beträgt.

Die von der Objektebene OBJ ausgehenden Strahlenbüschel werden in der Bildebene IM auf je ein Spotbild fokussiert. Innerhalb des Bildfeldes beträgt für alle Bildpunkte der maximale Durchmesser der Spotbilder 260$\mu$m.

Die Pupillenfunktion des REMA-Objektives 509 läßt sich als Polynomreihe gemäß Gleichung (1) entwickeln, deren Koeffizienten in Tabelle 6 gegeben sind.

Tabelle 6: Koeffizienten der Polynomreihe

| | Koeffizient | Polynombeiträge bei $Y_{im}^{max} = 56,6\text{mm}$ |
|---|---|---|
| $c_1$ | -5,341302E-01 mrad/mm | -30,23 mrad |
| $C_3$ | 2,526716E-04 mrad/mm$^3$ | 45,81 mrad |
| $C_5$ | -8,320880E-09 mrad/mm$^5$ | -4,83 mrad |

EP 1 235 112 B1

(fortgesetzt)

| | Koeffizient | Polynombeiträge bei $Y_{im}^{max} = 56,6mm$ |
|---|---|---|
| $C_7$ | 2,120363E-12 mrad/mm$^7$ | 3,95 mrad |
| $C_9$ | -6,339048E-17 mrad/mm$^9$ | -0,38 mrad |

Tabelle 6 ist zu entnehmen, daß der größte Beitrag zur sphärischen Aberration der Pupillenabbildung für die maximale positive Feldhöhe $Y_{im}^{max}$ der Beitrag dritter Ordnung mit +45,8 ist. Der gesamte nichtlineare Beitrag beträgt +44,5mrad, so daß die sphärische Aberration im Vergleich zum ersten Ausführungsbeispiel eines REMA-Objektives noch deutlich stärker überkorrigiert ist. Das Verhältnis von nichtlinearem Beitrag zu linearem Beitrag beträgt für die maximale Feldhöhe $Y_{im}^{max}$ -1,47.

Das zweite Teilobjektiv 501 des REMA-Objektivs ist aus einer ersten Linsengruppe 503 und einer zweiten Linsengruppe 505 aufgebaut. Zu der ersten Linsengruppe 503 sind die Linsen L56 und L57 zu rechnen, wobei Linse L56 ein Meniskus mit positiver Brechkraft und Linse L57 ein Meniskus mit negativer Brechkraft ist. Die konvexe Fläche der Menisken ist dabei jeweils der Blendenebene APE zugewandt. Die Linse L56 weist die asphärische Linsenfläche S513 auf.

Die zweite Linsengruppe 505 des zweiten Teilobjektivs 501 ist aus dem Meniskus L58 mit positiver Brechkraft, dessen konvexe Linsenfläche der Blendenebene APE zugewandt ist, dem Meniskus L59 mit positiver Brechkraft, dessen konvexe Linsenfläche der Bildebene IM zugewandt ist, der Bikonvexlinse L510 mit positiver Brechkraft, sowie dem Meniskus L511 mit negativer Brechkraft, dessen konvexe Fläche der Blendenebene APE zugewandt ist, aufgebaut. Die Linsenfläche S523 ist eine asphärische Linsenfläche, deren Flächenbeschreibung in Tabelle 5 gegeben ist. Der Radius der Hüllsphäre, welche die asphärische Linsenfläche S523 am Scheitel und am Rand des ausgeleuchteten Bereichs der asphärischen Linsenfläche S523 bei 99,6mm schneidet, beträgt-238,6mm, so daß die maximale Pfeilhöhenabweichung zwischen der asphärischen Linsenfläche S523 und der Hüllsphäre -1,61mm beträgt. Die zweite Linsengruppe 505 enthält eine weitere asphärische Linsenfläche S518, um die große Überkorrektur der sphärischen Aberration der Pupillenabbildung bereitstellen zu können. Der Radius der Hüllsphäre, welche die asphärische Linsenfläche S518 am Scheitel und am Rand des ausgeleuchteten Bereichs der asphärischen Linsenfläche bei 109,9mm schneidet, beträgt 170,1mm, so daß die maximale Pfeilhöhenabweichung zwischen der asphärischen Linsenfläche S518 und der Hüllsphäre 1,66mm beträgt.

Die Linse L511 weist eine zur Bildebene IM konkave Linsenfläche S525 auf, wobei das Verhältnis von Krümmungsradius zu Linsendurchmesser 0,70 beträgt. Die Linse L511 mit negativer Brechkraft ist die letzte Linse mit Brechkraft vor der Bildebene IM, so daß die konkave Linsenfläche S525 unmittelbar vor der Bildebene IM angeordnet ist. Der freie Arbeitsabstand zwischen der letzten Linse und der Bildebene IM beträgt 67,9mm.

Die Linsen der zweiten Linsengruppe 505 des zweiten Teilobjektives 501 sind auf Minimierung der Störreflexe optimiert. Kritisch für Störreflexe sind im REMA-Objektiv 509 der Figur 5 die Linsenflächen S519, S522, S524 und S525, während bei den Linsenflächen S518, S520, S521 und S523 der am Retikel und den benannten Linsenflächen reflektierte äußerte Hauptstrahl HS nicht mehr in die Bildebene gelangt. Bei Störreflexen zwischen der Bildebene IM und der Linsenfläche S519 schneidet der äußerste Hauptstrahl HS die Bildebene IM bei einer Höhe von 40,1mm, was einem Höhenverhältnis von 70,9% in Bezug auf die maximale Feldhöhe $Y_{im}^{max}$ von 56,6mm entspricht. Bei Störreflexen zwischen der Bildebene IM und der Linsenfläche S522 schneidet der äußerste Hauptstrahl HS die Bildebene IM bei einer Höhe von 58,6mm, was einem Höhenverhältnis von 103,5% in Bezug auf die maximale Feldhöhe $Y_{im}^{max}$ entspricht. Bei Störreflexen zwischen der Bildebene IM und der Linsenfläche S524 schneidet der äußerste Hauptstrahl HS die Bildebene IM bei einer Höhe von 52,4mm, was einem Höhenverhältnis von 92,6% in Bezug auf die maximale Feldhöhe $Y_{im}^{max}$ entspricht. Bei Störreflexen zwischen der Bildebene IM und der Linsenfläche S525 schneidet der äußerste Hauptstrahl HS die Bildebene IM bei einer Höhe von 180,7mm, was einem Höhenverhältnis von 319,3% in Bezug auf die maximale Feldhöhe $Y_{im}^{max}$ entspricht.

Die konkave Linsenfläche S525 weist einen Krümmungsradius von 96,08mm und einen Abstand von der Bildebene IM von 96,71mm auf, so daß die Brennebene der konkaven Linsenfläche S525, die zur Berechnung der Störreflexe als Spiegel fungiert, einen Abstand von 48,7mm zur Bildebene IM hat. Das Verhältnis dieses Abstandes zum halben Krümmungsradius beträgt 1,0, so daß sich ein möglicher Störreflex nur unwesentlich auswirkt.

Damit das Mittenbüschel mit geringen Inzidenzwinkeln auf die konkave Linsenfläche S521 trifft und somit geringe Aberrationen für die Feldabbildung eingeführt werden, wird die konkave Linsenfläche S521 möglichst konzentrisch zur Bildebene IM angeordnet. Das Verhältnis des Abstandes der Bildebene IM von dem Scheitel der konkaven Linsenfläche S521 zum Betrag des Krümmungsradius der konkaven Linsenfläche S521 beträgt 1,01.

Die Winkelabweichung zwischen den energetischen Schwerstrahlen und den Hauptstrahlen für das REMA-Objektiv 509 der Figur 5 ist in Figur 6 als durchgezogenen Linie 613 für positive Feldhöhen dargestellt. Sie ist für alle Feldhöhen kleiner als $\pm 0{,}5$ mrad.

Figur 7 zeigt in schematischer Darstellung ein erstes Ausführungsbeispiel einer Mikrolithographie-Projektionsbelichtungsanlage 715, die in diesem Fall zwei Lichtquellen 717 und 717' aufweist. Als Lichtquelle 717 kann unter anderem ein DUV- oder VUV-Laser eingesetzt werden, beispielsweise ein ArF-Laser für 193nm, ein $F_2$-Laser für 157nm, ein $Ar_2$-Laser für 126nm und ein NeF-Laser für 109nm. Durch eine Strahlformungsoptik 719 wird ein paralleles Lichtbündel erzeugt, das auf ein Divergenz erhöhendes optisches Element 721 trifft. Als Divergenz erhöhendes optisches Element 721 kann beispielsweise eine Rasterplatte aus diffraktiven oder refraktiven Rasterelementen eingesetzt werden. Jedes Rasterelement erzeugt ein Strahlenbüschel, dessen Winkelverteilung durch Ausdehnung und Brennweite des Rasterelementes bestimmt ist. Die Rasterplatte befindet sich in der Objektebene eines nachfolgenden Objektives 723 oder in deren Nähe. In der Blendenebene 725 des Objektives 723 werden die von den Rasterelementen erzeugten Strahlenbüschel überlagert. Das Objektiv 723 kann als Zoom-Objektiv auslegt sein, um die Ausdehnung der Ausleuchtung der Blendenebene 725 zu variieren. Durch den Einsatz von zwei entlang der optischen Achse verschiebbaren Axikonlinsen unmittelbar vor der Blendenebene 725 kann auch eine annulare Ausleuchtung mit variabler Ringbreite erzielt werden. Ein derartiges Zoom-Axikon-Objektiv ist aus DE 44 41 947 A bekannt. Durch Tausch des Apertur erzeugenden Elementes 721 kann ebenfalls die Ausleuchtung variiert werden. Spezielle Apertur erzeugende Elemente 721 lassen auch die sogenannte Quadrupol-Beleuchtung mit vier separierten Bereichen zu. Die Blendenebene 725 des Objektivs 723 ist die Eintrittsebene eines Wabenkondensors 727. In der Nähe der Austrittsebene des Wabenkondensors 727 befindet sich eine Blendenebene APE des gesamten Beleuchtungssystems. In der Blendenebene APE kann die Ausleuchtung zusätzlich über Masken 729 oder Transmissionsfilter gesteuert werden. Auf den Wabenkondensor 727 folgt das Teilobjektiv 701 der Figur 1. Die den Elementen von Figur 1 entsprechenden Elemente in Figur 7 haben die gleichen Bezugszeichen wie in Figur 1 vermehrt um die Zahl 700. Für eine Beschreibung dieser Elemente wird auf die Beschreibung zu Figur 1 verwiesen. Zwischen der ersten Linsengruppe 703 und zweiten Linsengruppe 705 des Teilobjektives 701 befindet sich ein Polarisations-Strahlteilerwürfel 731, der die von den Lichtquellen 717 und 717' ausgehenden Strahlengänge überlagert. Bis zum Strahlteilerwürfel 731 sind somit alle Komponenten der Beleuchtungseinrichtung zweifach vorhanden. Die Komponenten des zweiten Systemastes 737 bis zum Strahlteilerwürfel 731 weisen im Vergleich zum ersten Systemast 735 gestrichene Bezugszeichen auf. Damit die Überlagerung möglichst verlustfrei erfolgt, muß das Licht, das an der Strahlteilerfläche 733 transmittiert werden soll, in der Einfallsebene polarisiert sein, während das Licht, das an der Strahlteilerfläche 733 reflektiert werden soll, senkrecht zur Einfallsebene polarisiert sein muß. Dies läßt sich erreichen, indem in der Blendenebene APE polarisationsdrehende oder polarisationsselektive Mittel wie Polarisationsfilter oder $\lambda/4$-Platten angebracht sind. Erzeugt die Lichtquelle 717 bereits linear polarisiertes Licht, so kann durch Ausrichtung der Lichtquelle 717 der Polarisationszustand entsprechend eingestellt werden. In der Bildebene IM des Teilobjektives befindet sich das Retikel 739, das mit einem Projektionsobjektiv 741 auf den Wafer 743 abgebildet wird. Sowohl Retikel 739 wie auch Wafer 743 befinden sich auf einer nicht dargestellten Haltevorrichtung. Diese Haltevorrichtung läßt den Austausch von Retikel 739 und Wafer 743 zu. In sogenannten Scanner-Systemen werden Retikel 739 und Wafer 743 im Verhältnis des Abbildungsmaßstabes des Projektionsobjektives 741 in Scan-Richtung bewegt.

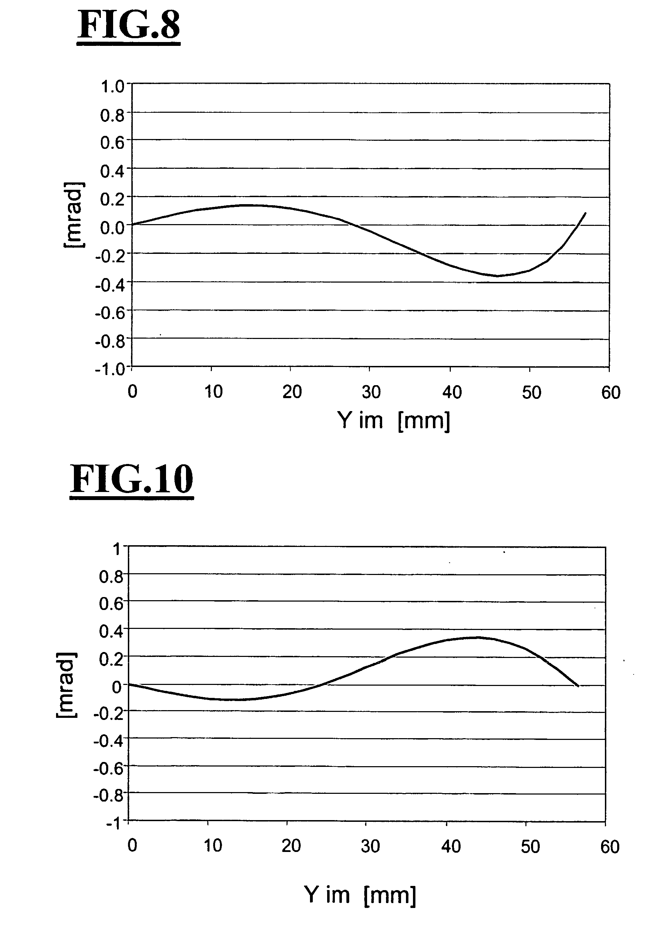

Für das in Figur 7 nur schematisch dargestellte Projektionsobjektiv kann das Projektionsobjektiv der Figur 2 der DE 199 42 281.8 eingesetzt werden, das einen Abbildungsmaßstab von -0,25 aufweist. Die Systemdaten zu diesem Projektionsobjektiv sind in Tabelle 1 der DE 199 42 281.8 gegeben, wobei der Abstand zwischen der Objektebene und dem Scheitel der Linse L101 49,2885mm beträgt. Die Pupillenfunktion des Teilobjektives 701 der Figur 1, dessen Systemdaten in Tabelle 1 der vorliegenden Anmeldung gegeben sind, ist an die Verteilung der Objektiv-Hauptstrahlwinkel des Projektionsobjektives 741 genau angepaßt. Figur 8 zeigt die Abweichung der Pupillenfunktion des Teilobjektives 701 von der Verteilung der Objektiv-Hauptstrahlwinkel als durchgezogene Linie 845. Die maximale Abweichung beträgt $\pm 0{,}4$ mrad. Durch die Anpassung des Teilobjektives 701 an das Projektionsobjektiv 741 ist es möglich, eine erhebliche Unterkorrektur der sphärischen Aberration der Pupillenaberration bei dem Projektionsobjektiv 741 zuzulassen.

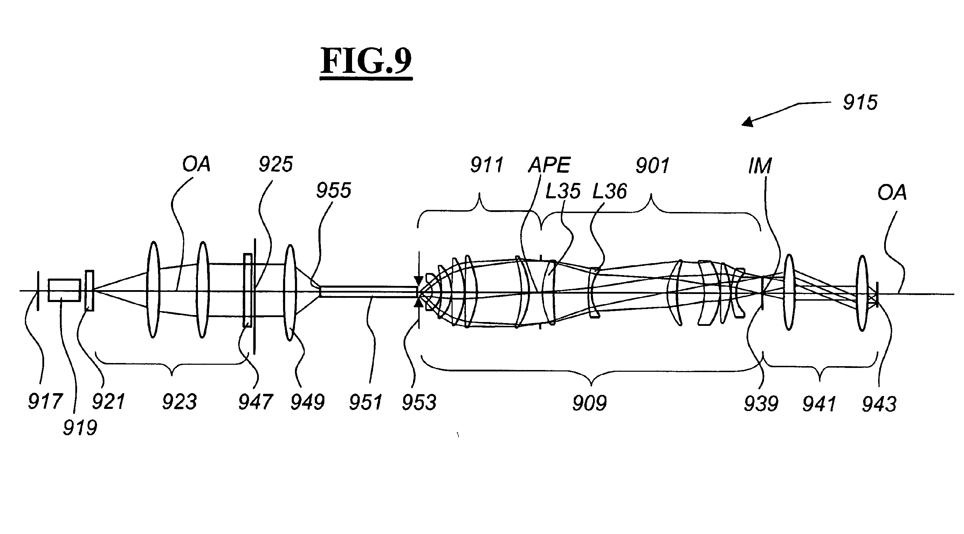

Figur 9 zeigt in schematischer Darstellung ein zweites Ausführungsbeispiel einer Mikrolithographie-Projektionsbelichtungsanlage 915. Die den Elementen von Figur 7 entsprechenden Elemente in Figur 9 haben die gleichen Bezugszeichen wie in Figur 7 vermehrt um die Zahl 200. Für eine Beschreibung dieser Elemente wird auf die Beschreibung zu Figur 7 verwiesen. Im zweiten Ausführungsbeispiel wird jedoch ein Glasstab 951 zur Homogenisierung der Lichtverteilung eingesetzt. Anstelle des Wabenkondensors und des Teilobjektives weist die Mikrolithographie-Projektionsbelichtungsanlage 915 ein weiteres Divergenz erhöhendes optisches Element 947, das Einkoppelobjektiv 949, den Glasstab 951, die Maskierungseinrichtung 953 und das REMA-Objektiv 909 auf, das die Maskierungseinrichtung 953 auf das Retikel 939 abbildet. Derartige Beleuchtungssysteme werden in der DE 195 20 563 A1 (US serial number 09/315267) beschrieben. Das REMA- Objektiv 909 ist dabei identisch zu dem REMA-Objektiv 309 der Figur 5, dessen Systemdaten in Tabelle 3 gegeben sind.

Der Glasstab 951 erzeugt in der Eintrittsebene 955 des Glasstabes 951 entsprechend der Anzahl der Reflexionen innerhalb des Glasstabes 951 virtuelle sekundäre Lichtquellen, die durch das erste Teilobjektiv 911 des REMA-Objektives 909 abgebildet werden. Die Bilder der virtuellen sekundären Lichtquellen liegen dabei nicht in der Blendenebene APE, sondern in Richtung der Bildebene IM defokussiert. Während das erste Teilobjektiv 911 die im Unendlichen liegende Eintrittspupille auf die Blendenebene APE abbildet, werden die im Abstand der Glasstablänge liegenden virtuellen sekundären Lichtquellen in den Bereich zwischen den Linsen L35 und L36 abgebildet. Das REMA-Objektiv 909 ist vorteilhaft derart ausgelegt, daß die Ebene mit den Bildern der virtuellen sekundären Lichtquellen und den damit verbundenen starken Intensitätsschwankungen nicht auf einer Linse zu liegen kommt, um Materialschädigungen zu vermeiden. Dies wird erreicht, indem die Linse L35 nahe der Blendenebene APE angeordnet ist, während zwischen der Linse L35 und L36 ein ausreichend großer Luftraum vorhanden ist. Eine andere Möglichkeit wäre, für Linsen am Ort der Bilder der virtuellen sekundären Lichtquellen strahlungsbeständige Linsenmaterialien wie Fluorid-Kristalle einzusetzen.

Durch den Glasstab 951 wird in der Objektebene des REMA-Objektives 909 ein rechteckiges Feld beleuchtet, in dem die Intensitätsschwankungen kleiner 2 % sind. Das REMA-Objektiv 909 bildet dieses homogen beleuchtete Feld auf das Retikel ab, wobei die Beleuchtungsverteilung auf dem Retikel nahezu unabhängig von der Ausleuchtung der Blendenebene APE ist, die zuvor beispielsweise mit einem Zoom-Axikon-Objektiv eingestellt wurde. Die Intensitätsschwankungen, die durch die variable Blendenausleuchtung erzeugt werden, sind vorteilhafterweise kleiner $\pm 1\%$. Beim REMA-Objektiv 909 betragen die Intensitätsschwankungen nur $\pm 0{,}2\%$. Dies gelingt durch die Korrektur der aperturabhängigen Bildfehler.

Für das in Figur 9 nur schematisch dargestellte Projektionsobjektiv kann das Projektionsobjektiv der Figur 8 der DE 199 42 281.8 eingesetzt werden, das einen Abbildungsmaßstab von -0,25 aufweist. Die Systemdaten sind in Tabelle 4 dieser Patentschrift gegeben, wobei der Abstand zwischen der Objektebene und dem Scheitel der Linse L401 33,4557mm beträgt. Die Pupillenfunktion des REMA-Objektives 909 ist an die Verteilung der Objektiv-Hauptstrahlwinkel des Projektionsobjektives 934 genau angepaßt. Figur 10 zeigt die Abweichung der Pupillenfunktion des Teilobjektives von der Verteilung der Objektiv-Hauptstrahlwinkel als durchgezogenen Linie 1045. Die maximale Abweichung beträgt 0,34mrad.

Mit den Ausführungsbeispielen wird eine Möglichkeit aufgezeigt, Beleuchtungssysteme bereit zu stellen, die eine Unterkorrektur der sphärischen Aberration der Pupillenabbildung in einem nachfolgenden Projektionsobjektiv zulassen. Dadurch lassen sich Korrektionsmittel innerhalb des Projektionsobjektives einsparen.

| Linse | Fläche | Radius [mm] | Dicke [mm] | Material | Durchmesser [mm] |
|-------|--------|-------------|------------|----------|------------------|
|       | APE    | 0.00        | 15.59      |          | 187.9            |
| L11   | S102   | 260.32      | 39.87      | SiO2     | 195.5            |
|       | S103   | 567.25      | 135.51     |          | 191.1            |
| L12   | S104   | 234.09      | 15.00      | SiO2     | 184.3            |
|       | S105   | 180.39      | 259.04     |          | 178.1            |
|       | S106   | 0.00        | 206.08     |          | 213.7            |
| L13   | S107   | 1539.49     | 38.23      | SiO2     | 245.5            |
|       | S108   | -306.69     | 52.29      |          | 245.8            |
| L14   | S109   | 130.37      | 52.39      | SiO2     | 190.4            |
|       | S110   | 844.68      | 15.14      |          | 175.2            |
| L15   | S111   | 555.42      | 5.86       | SiO2     | 160.8            |
|       | S112   | 100.69      | 79.74      |          | 134.3            |
|       | IM     | 0.00        | 0.00       |          | 116.0            |

$$z = \frac{\frac{1}{R}h^2}{1 + \sqrt{1 - (1 - EX)\left(\frac{1}{R}\right)^2 h^2}} + \sum_{k=1} c_k h^{2k+2}$$

z: Pfeilhöhe; h: Höhe; R: Radius; EX: Exzentrizität; $C_k$: Asphärenkonstanten

Tabelle 1: Optische Daten des Teilobjektives der Figur 1

| Fläche | EX | C1 | C2 | C3 | C4 |
|--------|------|------|------|------|------|
| S102 | -0.6130 | -9.1133E-09 | 1.0931E-12 | -1.1885E-16 | 4.3105E-21 |
| S104 | 3.5118 | 2.6731E-08 | -1.1221E-12 | 7.9601E-17 | -4.1294E-21 |
| S111 | 2.0197E+12 | -5.5586E-08 | 4.3580E-12 | -1.9413E-16 | 2.3919E-21 |

| | Fläche | Radius [mm] | Dicke [mm] | Material | Durchmesser [mm] |
|------|--------|-------------|------------|----------|------------------|
| | OBJ | 0.00 | 32.95 | | 31.2 |
| L31 | S302 | -38.69 | 37.88 | CaF2 | 61.9 |
| | S303 | -73.41 | 0:90 | | 114.4 |
| L32 | S304 | 2696.07 | 33.32 | CaF2 | 168.2 |
| | S305 | -191.13 | 0.90 | | 178.0 |
| L34 | S306 | 329.78 | 41.98 | SiO2 | 216.0 |
| | S307 | -514.77 | 28.53 | | 219.1 |
| L35 | S308 | 334.07 | 34.03 | SiO2 | 227.6 |
| | S309 | -570.33 | 161.49 | | 227.6 |
| | APE | 0.00 | 6.00 | | 188.0 |
| L36 | S311 | 130.20 | 30.35 | SiO2 | 195.8 |
| | S312 | 324.12 | 99.95 | | 192.5 |
| L37 | S313 | 211.39 | 11.40 | SiO2 | 168.8 |
| | S314 | 127.10 | 230.32 | | 158.8 |
| | S315 | 0.00 | 216.90 | | 197.4 |
| L38 | S316 | -851.36 | 37.33 | SiO2 | 237.1 |
| | S317 | -237.99 | 0.90 | | 240.0 |
| L39 | S318 | 133.05 | 46.59 | SiO2 | 212.7 |
| | S319 | 275.70 | 42.03 | | 200.4 |
| L310 | S320 | 240.69 | 12.00 | SiO2 | 162.1 |
| | S321 | 101.80 | 91.62 | | 138.5 |
| | IM | 0.00 | 0.00 | | 116.2 |

$$z = \cfrac{\frac{1}{R}h^2}{1+\sqrt{1-(1-EX)\left(\frac{1}{R}\right)^2 h^2}} + \sum_{k=1} c_k h^{2k+2}$$

z: Pfeilhöhe; h: Höhe; R: Radius; EX: Exzentrizität; $C_k$: Asphärenkonstanten

Tabelle 3: Optische Daten des Teilobjektives der Figur 3

| Fläche | EX | C1 | C2 | C3 | C4 |
|--------|-----|-----|-----|-----|-----|
| S308 | -2.4978 | -4.3481E-08 | -7.8594E-14 | -2.0935E-17 | 8.6082E-23 |
| S311 | 0.2840 | -4.1616E-08 | -1.1523E-12 | -4.8136E-18 | -5.8384E-21 |
| S313 | 0.6222 | -3.5043E-08 | 1.0875E-12 | 2.1557E-16 | -3.6907E-21 |
| S320. | 0.9715 | -5.9896E-08 | -2.8284E-12 | 1.2407E-16 | 2.9936E-21 |

| Linse | Fläche | Radius [mm] | Dicke [mm] | Material | Durchmesser [mm] |
|-------|--------|-------------|------------|----------|-------------------|
|  | OBJ | 0.00 | 44.12 |  | 32.4 |
| L51 | S502 | -42.28 | 30.35 | SiO2 | 73.0 |
|  | S503 | -78.14 | 0.90 |  | 121.7 |
| L52 | S504 | -338.66 | 37.30 | SiO2 | 163.1 |
|  | S505 | -124.59 | 0.86 |  | 177.2 |
| L53 | S506 | 2979.91 | 45.50 | SiO2 | 221.0 |
|  | S507 | -219.18 | 1.65 |  | 228.3 |
| L54 | S508 | 5302.65 | 40.00 | SiO2 | 241.5 |
|  | S509 | -230.16 | 156.30 |  | 244.0 |
| L55 | S510 | -377.28 | 26.00 | SiO2 | 241.3 |
|  | S511 | -224.20 | 40.60 |  | 243.4 |
|  | APE | 0.00 | 6.00 |  | 217.2 |
| L56 | S513 | 212.83 | 39.70 | SiO2 | 216.9 |
|  | S514 | 1296.09 | 120.30 |  | 211.7 |
| L57 | S515 | 523.30 | 11.70 | SiO2 | 166.8 |
|  | S516 | 128.28 | 148.73 |  | 155.8 |
|  | S517 | 0.00 | 113.55 |  | 233.3 |
| L58 | S518 | 146.29 | 33.90 | SiO2 | 219.7 |
|  | S519 | 345.28 | 94.30 |  | 216.2 |
| L59 | S520 | -268.89 | 55.00 | SiO2 | 208.1 |
|  | S521 | -200.89 | 0.80 |  | 216.3 |
| L510 | S522 | 1616.33 | 35.50 | SiO2 | 202.3 |
|  | S523 | -174.93 | 2.20 |  | 199.1 |

(fortgesetzt)

| Linse | Fläche | Radius [mm] | Dicke [mm] | Material | Durchmesser [mm] |
|---|---|---|---|---|---|
| L511 | S524 | 256.46 | 15.90 | SiO2 | 163.9 |
| | S525 | 96.08 | 96.71 | | 137.4 |
| | IM | 0.00 | 0.00 | | 113.3 |

$$z = \frac{\dfrac{1}{R} h^2}{1 + \sqrt{1 - (1 - EX)\left(\dfrac{1}{R}\right)^2 h^2}} + \sum_{k=1} c_k h^{2k+2}$$

z: Pfeilhöhe; h: Höhe; R: Radius; EX: Exzentrizität; $C_k$: Asphärenkonstanten

Tabelle 5: Optische Daten des Teilobjektives der Figur 5

| Fläche | EX | C1 | C2 | C3 | C4 | C5 |
|---|---|---|---|---|---|---|
| S509 | -1.1741 | 3.9084E-08 | 3.8630E-13 | 6.5586E-17 | -3.3899E-21 | 1.2432E-25 |
| S513 | -0.2501 | -2.1870E-08 | 5.4913E-14 | -7.7358E-17 | 4.1956E-21 | -1.2014E-25 |
| S518 | 0.2356 | -3.4023E-08 | -1.0405E-12 | 7.3414E-17 | -9.7841E.21 | 3.0608E-25 |
| S523 | -0.8321 | 1.4350E-07 | -4.9565E-12 | 5.7530E-16 | -3.6123E-20 | 1.5494E-24 |

### Patentansprüche

1. Teilobjektiv (1, 301, 501) mit einer optischen Achse (OA) zur Beleuchtung eines Bildfeldes, insbesondere eines Bildfeldes einer Beleuchtungseinrichtung einer Mikrolithographie-Projektionsbelichtungsanlage, wobei

   - das Teilobjektiv (1,301,501) eine Bledenebene (APE) und eine Bildebene (IM) aufweist,

   - die maximale Feldhöhe $Y_{im}^{max}$ innerhalb des Bildfeldes mindestens 40mm beträgt,

   - von der Blendenebene (APE) Strahlbüschel mit je einem Hauptstrahl ausgehen, wobei die Schnittpunkte der Hauptstrahlen mit der optischen Achse (OA) maximal 10% des Durchmessers der Blendenebene (APE) auseinander liegen, und
   - das Teilobjektiv (1, 301, 501) eine erste Linsengruppe (3, 303, 503) und eine zweite Linsengruppe (5, 305, 505) umfaßt,
   wobei innerhalb der ersten Linsengruppe (3, 303, 503) ein äußerster Hauptstrahl (HS), der mit maximalem Winkel zur optischen Achse (OA) durch die Blendenebene (APE) läuft, dem Betrag nach kleinere Strahlhöhen an den Linsenflächen aufweist als ein Randstrahl (RS), der das Strahlbüschel begrenzt, dessen Hauptstrahl entlang der optischen Achse (OA) verläuft,
   während innerhalb der zweiten Linsengruppe (5, 305, 505) der äußerste Hauptstrahl (HS) dem Betrag nach größere Strahlhöhen an den Linsenflächen aufweist als der genannte Randstrahl (RS), und
   wobei die zweite Linsengruppe (5, 305, 505) eine Linse (L15, L39, L510) mit einer ersten asphärischen Linsenfläche (S111, S320, S523) aufweist,

   **dadurch gekennzeichnet,**

   - **daß** die zweite Linsengruppe (5, 305, 505) mindestens eine erste Linse (L15, L39, L511) mit negativer Brechkraft und mindestens eine zweite Linse (L14, L38, L58) mit positiver Brechkraft aufweist,
   - die bildseitige numerische Apertur mindestens 0,15 beträgt, und
   - die Hauptstrahlen innerhalb des Bildfeldes eine Feldhöhe $Y_{im}$ und einen Hauptstrahlwinkel PF zwischen der Flächennormalen der Bildebene (IM) und dem jeweiligen Hauptstrahl aufweisen, wobei die Verteilung der Hauptstrahlwinkel PF über der Feldhöhe $Y_{im}$ durch eine Pupillenfunktion $PF(Y_{im})$ gegeben ist, die sich aus einem linearen und einem nichtlinearen Beitrag zusammensetzt

$$PF(Y_{im}) = c_1 \cdot Y_{im} + PF_{NL}(Y_{im}),$$

wobei $c_1$ der Steigung der Pupillenfunktion bei der Feldhöhe $Y_{im} = 0mm$ entspricht und der nichtlineare Beitrag $PF_{NL}(Y_{im})$ für die maximale positive Feldhöhe $Y_{im}^{max}$ mindestens +15mrad beträgt.

**2.** Teilobjektiv nach Anspruch 1, wobei die erste Linse (L15, L39, L511) eine zur Bildebene (IM) konkave Linsenfläche (S112, S321, S525) aufweist.

**3.** Teilobjektiv nach Anspruch 2, mit einem Krümmungsradius und einem Linsendurchmesser der konkaven Linsenfläche (S112, S321, S525), wobei das Verhältnis des Krümmungsradius zu dem Linsendurchmesser kleiner als 1,0, vorzugsweise kleiner als 0,8 ist.

**4.** Teilobjektiv nach einem der Ansprüche 2 bis 3, wobei die erste Linse (L39, L511) ein Meniskus ist.

**5.** Teilobjektiv nach einem der Ansprüche 2 bis 4, wobei in Bezug auf die Lichtrichtung nach der ersten Linse (L15, L39, L511) keine weitere Linse mit optischer Brechkraft angeordnet ist.

**6.** Teilobjektiv nach Anspruch 5, mit einem Abstand des Scheitels der konkaven Linsenfläche (S112, S321, S525) von der Bildebene (IM) und mit einem Betrag des Krümmungsradius der konkaven Linsenfläche (S112, S321, S525), wobei das Verhältnis von besagtem Abstand zu besagtem Betrag einen Wert zwischen 0,7 und 1,3 aufweist.

**7.** Teilobjektiv nach einem der Ansprüche 5 und 6, mit einem ersten Abstand des Scheitels der konkaven Linsenfläche (S112, S321, S525) von der Bildebene (IM), mit einem durch den halben Krümmungsradius der konkaven Linsenfläche (S 112, S321, S525) gegebenen zweiten Abstand und mit einer Differenz zwischen dem ersten und zweiten Abstand, wobei der Betrag des Verhältnisses von der genannter Differenz zu dem zweiten Abstand größer als 0,3 ist.

**8.** Teilobjektiv nach einem der Ansprüche 1 bis 7, wobei die Bildebene (IM) und die Linsenflächen der zweiten Linsengruppe (5, 305, 505) die einfallenden Strahlen teilweise reflektieren und wobei der äußerste Hauptstrahl (HS) nach einer Reflexion an der Bildebene (IM) und einer Reflexion an einer Linsenfläche der zweiten Linsengruppe (5, 305, 505) in der Bildebene (IM) eine Strahlhöhe aufweist, die mindestens 30% der maximalen Feldhöhe $Y_{im}^{max}$ beträgt.

**9.** Teilobjektiv nach einem der Ansprüche 1 bis 8, mit einer Pfeilhöhenabweichung der ersten asphärischen Linsenfläche (S111, S320, S523) zu einer Hüllsphäre, welche die asphärische Linsenfläche (S111, S320, S523) im Scheitel und am Rand des ausgeleuchteten Bereiches der asphärischen Linsenfläche (S111, S320, S523) schneidet, wobei der Betrag der maximalen Pfeilhöhenabweichung mindestens 0,2mm, vorzugsweise mindestens 0,4mm beträgt.

**10.** Teilobjektiv nach einem der Ansprüche 1 bis 9, mit einem bildseitigen Arbeitsabstand, wobei der bildseitige Arbeitsabstand mindestens 30mm, vorzugsweise mindestens 40mm beträgt.

**11.** Teilobjektiv nach einem der Ansprüche 1 bis 10, wobei der nichtlineare Beitrag $PF_{NL}(Y_{im})$ für die maximale positive Feldhöhe $Y_{im}^{max}$ mindestens +25mrad beträgt.

**12.** Teilobjektiv nach einem der Ansprüche 1 bis 11, wobei mindestens eine weitere Linse (L58) der zweiten Linsengruppe (505) eine zweite asphärische Linsenfläche (S518) aufweist.

**13.** Teilobjektiv nach Anspruch 12, mit einer Pfeilhöhenabweichung der zweiten asphärischen Linsenfläche (S518) zu einer Hüllsphäre, welche die zweite asphärische Linsenfläche (S518) im Scheitel und am Rand des ausgeleuchteten Bereiches der zweiten asphärischen Linsenfläche (S518) schneidet, wobei der Betrag der maximalen Pfeilhöhenabweichung mindestens 0,2mm, vorzugsweise mindestens 0,4mm beträgt.

14. Teilobjektiv nach einem der Ansprüche 1 bis 13, wobei für die maximale Feldhöhe $Y_{im}^{max}$ das Verhältnis des nichtlinearen Beitrags $PF_{NL}(Y_{im}^{max})$ zum linearen Beitrag $c_1 \cdot Y_{im}^{max}$ Bereich von -0,5 und -2,0 liegt.

15. Teilobjektiv nach einem der Ansprüche 1 bis 14, wobei alle Strahlenbüschel, die die bildseitige numerische Apertur vollständig füllen, in der Bildebene (IM) innerhalb des Bildfeldes je ein Spotbild mit einem Durchmesser erzeugen und der maximale Durchmesser von allen Spotbildem 2% der maximalen Feldhöhe $Y_{im}^{max}$ beträgt.

16. Teilobjektiv nach einem der Ansprüche 1 bis 15, wobei die zweite Linse (L14, L38, L58) mit positiver Brechkraft ein Meniskus ist.

17. Teilobjektiv nach einem der Ansprüche 1 bis 16, wobei die zweite Linsengruppe (5, 305, 505) drei bis fünf Linsen mit endlicher Brennweite aufweist.

18. Teilobjektiv nach einem der Ansprüche 1 bis 17, wobei die zweite Linsengruppe (5, 505) eine Bikonvexlinse (L13, L510) aufweist.

19. REMA-Objektiv (309, 509) zur Abbildung eines Objektfeldes auf ein Bildfeld, umfassend

    - ein erstes Teilobjektiv (311, 511), das zwischen einer Objektebene (OBJ) und einer Blendenebene (APE) angeordnet ist, und
    - ein zweites Teilobjektiv (301, 501) nach mindestens einem der vorangehenden Ansprüche, das zwischen der Blendenebene (APE) und einer Bildebene (IM) angeordnet ist,

    wobei das erste Teilobjektiv (311, 511) und das zweite Teilobjektiv (301, 501) eine gemeinsame optische Achse (OA) aufweisen,
    von dem Objektfeld ausgehende Hauptstrahlen die optische Achse (OA) im Bereich der Blendenebene (APE) schneiden,
    und das REMA-Objektiv (309, 509) das Objektfeld mit drei- bis achtfacher Vergrößerung auf das Bildfeld in der Bildebene (IM) abbildet.

20. REMA-Objektiv nach Anspruch 19, wobei jedes Strahlenbüschel, das von einem Punkt innerhalb des Objektfeldes ausgeht und in der Bildebene (IM) die bildseitige numerische Apertur vollständig füllt, innerhalb des Bildfeldes ein Spotbild erzeugt und der maximale Durchmesser der Spotbilder maximal 2% der maximalen Feldhöhe $Y_{im}^{max}$ beträgt.

21. REMA-Objektiv nach einem der Ansprüche 19 und 20, wobei die Hauptstrahlen telezentrisch von der Objektebene (OBJ) ausgehen.

22. REMA-Objektiv nach einem der Ansprüche 19 bis 21, wobei für jede Feldhöhe $Y_{im}$ in der Bildebene (IM) ein Hauptstrahl und ein energetischer Schwerstrahl mit einer Winkelabweichung zwischen dem energetischem Schwerstrahl und dem Hauptstrahl gegeben sind und die maximale Winkelabweichung für alle Feldhöhen kleiner als 2mrad, vorzugsweise kleiner als 1mrad ist.

23. Mikrolithographie-Projektionsbelichtungsanlage (715, 915) umfassend

    - eine Beleuchtungseinrichtung mit einem Teilobjektiv (701, 901) nach mindestens einem der vorangehenden Ansprüche,
    - ein Projektionsobjektiv (741, 941), das ein Objektfeld in einer Objektebene auf ein Bildfeld in einer Bildebene abbildet, wobei das Projektionsobjektiv (741, 941) eine objektseitige Objektiv-Pupillenfunktion aufweist, die sich als Verteilung von Objektiv-Hauptstrahlwinkeln über Objekthöhen innerhalb des Objektfeldes des Projektionsobjektives (741, 941) ergibt,

    wobei das Teilobjektiv (701, 901) und das Projektionsobjektiv (741, 941) eine gemeinsame optische Achse (OA) aufweisen,

die Bildebene (IM) des Teilobjektives (701, 901) und die Objektebene des Projektionsobjektives (741, 941) in einer gemeinsamen Ebene liegen, und

die Abweichung der Pupillenfunktion des Teilobjektives von der objektseitigen Objektiv-Pupillenfunktion für alle Feldhöhen innerhalb des Bildfeldes des Teilobjektives (701, 901) kleiner als 2mrad, vorzugsweise kleiner als 1mrad ist.

**Claims**

1. Partial objective (1, 301, 501) having an optical axis (OA) for illuminating an image field, in particular an image field of an illumination device of a microlithography projection exposure machine, in which

   - the partial objective (1, 301, 501) has a stop plane (APE) and an image plane (IM),

   - the maximum field height $Y_{im}^{max}$ within the image field is at least 40 mm,

   - ray pencils with one principal ray each emanate from the stop plane (APE), the point of intersection of the principal rays with the optical axis (OA) lying at most 10% of the diameter of the stop plane (APE) apart from one another, and

   - the partial objective (1, 301, 501) comprises a first lens group (3, 303, 503) and a second lens group (5, 305, 505), within the first lens group (3, 303, 503) an outermost principal ray (HS), which runs through the stop plane (APE) at a maximum angle to the optical axis (OA), having smaller beam heights in terms of magnitude at the lens surfaces than a marginal ray (RS) which delimits the ray pencil, whose principal ray runs along the optical axis (OA), while within the second lens group (5, 305, 505) the outermost principal ray (HS) has larger beam heights in terms of magnitude at the lens surfaces than the said marginal ray (RS), and the second lens group (5, 305, 505) having a lens (L15, L39, L510) with a first aspheric lens surface (S111, S320, S523),

   **characterized**

   - **in that** the second lens group (5, 305, 505) has at least one first lens (L15, L39, L511) of negative reflective power and at least one second lens (L14, L38, L58) of positive refractive power,
   - the image-side numerical aperture is at least 0.15, and
   - the principal rays within the image field have a field height $Y_{im}$ and a principal ray angle PF between the surface normal to the image plane (IM) and the respective principal ray, the distribution of the principal ray angles PF over the field height $Y_{im}$ being given by a pupil function $PF(Y_{im})$ which is composed of a linear and a nonlinear contribution

   $$PF(Y_{im}) = c_1 \cdot Y_{im} + PF_{NL}(Y_{im}),$$

   $c_1$ corresponding to the gradient of the pupil function for the field height $Y_{im} = 0$ mm, and the nonlinear contribution

   $PF_{NL}(Y_{im})$ for the maximum positive field height $Y_{im}^{max}$ being at least +15 mrad.

2. Partial objective according to Claim 1, in which the first lens (L15, L39, L511) has a lens surface (S112, S321, S525) which is concave relative to the image plane (IM).

3. Partial objective according to Claim 2, having a radius of curvature and a lens diameter of the concave lens surface (8112, S321, S525), the ratio of the radius of curvature to the lens diameter being smaller than 1.0, preferably smaller than 0.8.

4. Partial objective according to either of Claim 2 and 3, in which the first lens (L39, L511) is a meniscus.

5. Partial objective according to one of Claims 2 to 4, in which no further lens with an optical reflective power is arranged downstream of the first lens (L15, L39, L511) with reference to the light direction.

6. Partial objective according to Claim 5, having a spacing of the vertex of the concave lens surface (S112, S321, S525) from the image plane (IM), and having a magnitude of the radius of curvature of the concave lens surface (S112, S321, S525), the ratio of the said spacing to the said magnitude having a value between 0.7 and 1.3.

7. Partial objective according to either of Claims 5 and 6, having a first spacing of the vertex of the concave lens surface (S112, S321, S525) from the image plane (IM), having a second spacing given by half the radius of curvature of the concave lens surface (S112, S321, S525), and having a difference between the first and second spacings, the magnitude of the ratio of the said difference to the said spacing being greater than 0.3.

8. Partial objective according to one of Claims 1 to 7, in which the image plane (IM) and the lens surfaces of the second lens group (5, 305, 505) partially reflect the incident rays, and in which after a reflection at the image plane (IM) and a reflection at a lens surface of the second lens group (5, 305, 505), the outermost principal ray (HS) has a ray height in the image plane (IM) which is at least 30% of the maximum field height $Y_{im}^{\max}$ .

9. Partial objective according to one of Claims 1 to 8, having a sagittal deviation of the first aspheric lens surface (S111, S320, S523) from an enveloping sphere which intersects the aspheric lens surface (S111, S320, S523) at the vertex and at the edge of the illuminated region of the aspheric lens surface (S111, S320, S523), the magnitude of the maximum sagittal deviation being at least 0.2 mm, preferably at least 0.4 mm.

10. Partial objective according to one of Claims 1 to 9, having an image-side working distance, the image-side working distance being at least 30 mm, preferably at least 40 mm.

11. Partial objective according to one of Claims 1 to 10, in which the nonlinear contribution $PF_{NL}(Y_{im})$ for the maximum positive field height $Y_{im}^{\max}$ is at least +25 mrad.

12. Partial objective according to one of Claims 1 to 11, in which at least one further lens (L58) of the second lens group (505) has a second aspheric lens surface (S518).

13. Partial objective according to Claim 12, having a saggital deviation of the second aspheric lens surface (S518) from an enveloping sphere which intersects the second aspheric lens surface (S518) at the vertex and at the edge of the illuminated region of the second aspheric lens surface (S518), the magnitude of the maximum sagittal deviation being at least 0.2 mm, preferably at least 0.4 mm.

14. Partial objective according to one of Claims 1 to 13, in which for the maximum field height $Y_{im}^{\max}$ the ratio of the nonlinear contribution $PF_{NL}(Y_{im}^{\max})$ to the linear contribution $c_1 \cdot Y_{im}^{\max}$ lies in the range from -0.5 to -2.0.

15. Partial objective according to one of Claims 1 to 14, in which all the ray pencils which completely fill the image-side numerical aperture each produce a spot image with a diameter in the image plane (IM) within the image field, and the maximum diameter of all the spot images is 2% of the maximum field height $Y_{im}^{\max}$ .

16. Partial objective according to one of Claims 1 to 15, in which the second lens (L14, L38, L58) of positive reflective power is a meniscus.

17. Partial objective according to one of Claims 1 to 16, in which the second lens group (5, 305, 505) has three to five lenses of finite focal length.

18. Partial objective according to one of Claims 1 to 17, in which the second lens group (5, 505) has a biconvex lens (L13, L510).

19. REMA objective (309, 509) for imaging an object field onto an image field, comprising

    - a first partial objective (311, 511) which is arranged between an object plane (OBJ) and a stop plane (APE), and
    - a second partial objective (301, 501) according to at least one of the preceding claims which is arranged between the stop plane (APE) and the image plane (IM) ,

in which the first partial objective (311, 511) and the second partial objective subsystem (301, 501) have a common optical axis (OA),
principal rays emanating from the object field intersect the optical axis (OA) in the region of the stop plane (APE), and the REMA objective (309, 509) images the object field onto the image field in the image plane (IM) with three- to eight-fold magnification.

20. REMA objective according to Claim 19, in which each ray pencil which emanates from a point within the object field and completely fills the image-side numerical aperture in the image plane (IM) produces a spot image within the image field and the maximum diameter of the spot images is at most 2% of the maximum field height $Y_{im}^{max}$.

21. REMA objective according to either of Claims 19 and 20, the principal rays emanating telecentrically from the object plane (OBJ).

22. REMA objective according to one of Claims 19 to 21, a principal ray and an energetic centroid ray having an angular deviation between the energetic centroid ray and the principal ray being given for each field height $Y_{im}$ in the image plane (IM), and the maximum angular deviation for all the field heights being smaller than 2 mrad, preferably smaller than 1 mrad.

23. Microlithography projection exposure machine (715, 915) comprising

- an illumination device having a partial objective (701, 901) according to at least one of the preceding claims,
- a projection objective (741, 941) which images an object field in an object plane onto an image field in an image plane, the projection objective (741, 941) having an object-side objective pupil function which results as a distribution of objective principal ray angles over object heights within the object field of the projection objective (741, 941),

in which the partial objective (701, 901) and the projection objective (741, 941) have a common optical axis (OA), the image plane (IM) of the partial objective (701, 901) and the object plane of the projection objective (741, 941) lying in a common plane, and the deviation of the pupil function of the partial objective from the object-side objective pupil function being smaller than 2 mrad, preferably smaller than 1 mrad, for all the field heights within the image field of the partial objective (701, 901).

## Revendications

1. Objectif partiel (1, 301, 501) comprenant un axe optique (OA) pour éclairer un champ d'image, notamment un champ d'image d'un dispositif d'éclairage d'un équipement d'éclairage par projection de microlithographie,

- l'objectif partiel (1, 301, 501) présentant un plan de diaphragme (APE) et un plan d'image (IM), la hauteur de champ maximale $Y_{im}^{max}$ à l'intérieur du champ d'image étant d'au moins 40 mm,
- un faisceau de rayons ayant chacun un rayon principal sortant du plan de diaphragme (APE), les points d'intersection des rayons principaux avec l'axe optique (OA) étant espacés les uns des autres au maximum de 10 % du diamètre du plan de diaphragme (APE) et
- l'objectif partiel (1, 301, 501) comprenant un premier groupe de lentilles (3, 303, 503) et un deuxième groupe de lentilles (5, 305, 505), un rayon principal le plus à extérieur (HS), lequel passe à travers le plan de diaphragme (APE) sous l'angle maximum par rapport à l'axe optique (OA), présentant à l'intérieur du premier groupe de lentilles (3, 303, 503) des valeurs de hauteurs de rayon au niveau des surfaces des lentilles plus petites qu'un rayon de bordure (RS) qui délimite le faisceau de rayons dont le rayon principal se propage le long de l'axe optique (OA), alors qu'à l'intérieur du deuxième groupe de lentilles (5, 305, 505), le rayon principal le plus à extérieur (HS) présentant des valeurs de hauteurs de rayon au niveau des surfaces des lentilles plus élevées qu'un rayon de bordure (RS) et le deuxième groupe de lentilles (5, 305, 505) présentant un lentille (L15, L39, L510) munie d'une première surface de lentille asphérique (S111, S320, S523),

**caractérisé en ce**

- **que** le deuxième groupe de lentilles (5, 305, 505) présente au moins une première lentille (L15, L39, L511) ayant une réfringence négative et au moins une deuxième lentille (L14, L38, L58) ayant une réfringence positive,

- l'ouverture numérique du côté de l'image est au moins de 0,15 et
- les rayons principaux à l'intérieur du champ d'image présentent une hauteur de champ $Y_{im}$ et un angle de rayon principal PF entre la normale à la surface du plan d'image (IM) et le rayon principal correspondant, la distribution de l'angle de rayon principal PF sur la hauteur du champ $Y_{im}$ étant définie par une fonction de pupille $PF(Y_{im})$ qui se compose d'une composante linéaire et d'une composante non linéaire $PF(Y_{im}) = c_1 \cdot Y_{im} + PF_{NL}(Y_{im})$, $c_1$ désignant la pente de la fonction de pupille avec une hauteur de champ $Y_{im} = 0$ mm et la composante non linéaire $PF_{NL}(Y_{im})$ pour la hauteur de champ positive maximale $Y_{im}^{max}$ étant d'au moins +15 mrad.

**2.** Objectif partiel selon la revendication 1, la première lentille (L15, L39, L511) présentant une surface de lentille (S112, S321, S525) concave par rapport au plan d'image (IM).

**3.** Objectif partiel selon la revendication 2, ayant un rayon de courbure et un diamètre de lentille de la surface de lentille concave (S112, S321, S525), le rapport entre le rayon de courbure et le diamètre de lentille étant inférieur à 1,0, de préférence inférieur à 0,8.

**4.** Objectif partiel selon l'une des revendications 2 à 3, la première lentille (L39, L511) étant un ménisque.

**5.** Objectif partiel selon l'une des revendications 2 à 4, aucune lentille supplémentaire ayant une réfringence optique n'étant disposée après la première lentille (L15, L39, L511) par rapport à la direction de la lumière.

**6.** Objectif partiel selon la revendication 5, présentant un espacement entre le sommet de la surface de lentille concave (S112, S321, S525) et le plan d'image (IM) et une valeur du rayon de courbure de la surface de lentille concave (S112, S321, S525), le rapport entre ledit espacement et ladite valeur ayant une valeur comprise entre 0,7 et 1,3.

**7.** Objectif partiel selon l'une des revendications 5 et 6, présentant un premier espacement entre le sommet de la surface de lentille concave (S112, S321, S525) et le plan d'image (IM), présentant un deuxième espacement déterminé par le demi rayon de courbure de la surface de lentille concave (S112, S321, S525) et présentant une différence entre le premier et le deuxième espacements, la valeur du rapport de ladite différence et le deuxième espacement étant supérieure à 0,3.

**8.** Objectif partiel selon l'une des revendications 1 à 7, le plan d'image (IM) et les surfaces de lentille du deuxième groupe de lentilles (5, 305, 505) réfléchissant partiellement les rayons incidents et le rayon principal le plus à l'extérieur (HS), après une réflexion sur le plan d'image (IM) et une réflexion sur une surface de lentille du deuxième groupe de lentilles (5, 305, 505) dans le plan d'image (IM) présentant une hauteur de rayon qui est au moins égale à 30 % de la hauteur de champ maximale $Y_{im}^{max}$.

**9.** Objectif partiel selon l'une des revendications 1 à 8, ayant un écart de montée d'arc de la première surface de lentille asphérique (S111, S320, S523) par rapport à une sphère d'enveloppe qui coupe la surface de lentille asphérique (S111, S320, S523) au sommet et au bord de la zone éclairée de la surface de lentille asphérique (S111, S320, S523), la valeur maximale de l'écart de montée d'arc étant d'au moins 0,2 mm, de préférence d'au moins 0,4 mm.

**10.** Objectif partiel selon l'une des revendications 1 à 9, présentant un espacement de travail côté image, l'espacement de travail côté image étant d'au moins 30 mm, de préférence d'au moins 40 mm.

**11.** Objectif partiel selon l'une des revendications 1 à 10, la composante non linéaire $PF_{NL}(Y_{im})$ pour la hauteur de champ positive maximale $Y_{im}^{max}$ étant d'au moins +25 mrad.

**12.** Objectif partiel selon l'une des revendications 1 à 11, au moins une lentille (L58) supplémentaire du deuxième groupe de lentilles (505) présentant une deuxième surface de lentille asphérique (S518).

**13.** Objectif partiel selon la revendication 12, ayant un écart de montée d'arc de la deuxième surface de lentille asphérique (S518) par rapport à une sphère d'enveloppe qui coupe la deuxième surface de lentille asphérique (S518) au sommet et au bord de la zone éclairée de la deuxième surface de lentille asphérique (S518), la valeur maximale de l'écart de montée d'arc étant d'au moins 0,2 mm, de préférence d'au moins 0,4 mm.

**14.** Objectif partiel selon l'une des revendications 1 à 13, le rapport entre la composante non linéaire $PF_{NL}(Y_{im}^{max})$ et la composante linéaire $c_1 \cdot Y_{im}^{max}$ pour la hauteur de champ positive maximale $Y_{im}^{max}$ étant comprise entre -0,5 et -2,0.

**15.** Objectif partiel selon l'une des revendications 1 à 14, tous les faisceaux de rayon qui remplissent entièrement l'ouverture numérique du côté de l'image générant à chaque fois une image ponctuelle dans le plan d'image (IM) à l'intérieur du champ d'image et le diamètre maximum de toutes les images ponctuelles étant égal à 2 % de la hauteur de champ maximale $Y_{im}^{max}$.

**16.** Objectif partiel selon l'une des revendications 1 à 15, la deuxième lentille (L14, L38, L58) avec une réfringence positive étant un ménisque.

**17.** Objectif partiel selon l'une des revendications 1 à 16, le deuxième groupe de lentilles (5, 305, 505) présentant trois à cinq lentilles ayant une distance focale finie.

**18.** Objectif partiel selon l'une des revendications 1 à 17, le deuxième groupe de lentilles (5, 505) présentant une lentille biconvexe (L13, L510).

**19.** Objectif REMA (309, 509) destiné à représenter un champ d'objet sur un champ d'image, comprenant

 - un premier objectif partiel (311, 511) qui est disposé entre le plan d'objet (OBJ) et un plan de diaphragme (APE) et
 - un deuxième objectif partiel (301, 501) selon au moins l'une des revendications précédentes qui est disposé entre le plan de diaphragme (APE) et un plan d'image (IM),

le premier objectif partiel (311, 511) et le deuxième objectif partiel (301, 501) présentant un axe optique (OA) commun, les rayons principaux sortant du champ d'objet croisant l'axe optique (OA) dans la zone du plan d'image (APE), et l'objectif REMA (309, 509) représentant le champ d'objet avec un grossissement de trois à huit fois sur le champ d'image dans le plan d'image (IM).

**20.** Objectif REMA selon la revendication 19, chaque faisceau de rayons qui sort d'un point à l'intérieur du champ d'objet et qui remplit entièrement l'ouverture numérique côté image dans le plan d'image (IM) générant une image ponctuelle à l'intérieur du champ d'image et le diamètre maximum des images ponctuelles étant égal à 2 % de la hauteur de champ maximale $Y_{im}^{max}$.

**21.** Objectif REMA selon l'une des revendications 19 et 20, les rayons principaux sortant de manière télécentrique du plan d'objet (OBJ).

**22.** Objectif REMA selon l'une des revendications 19 à 21, un rayon principal et un rayon lourd plus énergétique étant définis pour chaque hauteur de champ $Y_{im}$ dans le plan d'image (IM) avec un écart angulaire entre rayon lourd énergétique et le rayon principal et l'écart angulaire maximum pour toutes les hauteurs de champ étant inférieure à 2 mrad, de préférence inférieure à 1 mrad.

**23.** Équipement d'éclairage par projection de microlithographie (715, 915) comprenant

 - un dispositif d'éclairage muni d'un objectif partiel (701, 901) selon au moins l'une des revendications précédentes,
 - un objectif de projection (741, 941) qui représente un champ d'objet dans un plan d'objet sur un champ d'image dans un plan d'image, l'objectif de projection (741, 941) présentant une fonction de pupille d'objectif du côté de l'objet qui résulte de la distribution des angles du rayon principal de l'objectif sur les hauteurs d'objet à l'intérieur du champ d'objet de l'objectif de projection (741, 941),

l'objectif partiel (701, 901) et l'objectif de projection (741, 941) présentant un axe optique (OA) commun, le plan d'image (IM) de l'objectif partiel (701, 901) et le plan d'objet de l'objectif de projection (741, 941) se trouvant dans un plan commun et l'écart entre la fonction de pupille de l'objectif partiel et la fonction de pupille de l'objectif côté objet pour toutes les hauteurs de champ à l'intérieur du champ d'image de l'objectif partiel (701, 901) étant inférieur à 2 mrad, de préférence inférieur à 1 mrad.

# FIG.1

EP 1 235 112 B1

# FIG.2

Y im [mm]

## FIG.3

150.00 mm

EP 1 235 112 B1

# FIG.4

# FIG.6

**FIG.5**

509

L51 L53 L55 L56 L58 L510
OBJ L52 L54 APE L57 L59 L511 IM
OA HS
RS
S513 S518 S519 S523
S525

511 501
503 505

150.00 mm

28

EP 1 235 112 B1

**FIG.7**

EP 1 235 112 B1

## FIG.8

## FIG.10

# FIG.9

EP 1 235 112 B1